(19) 

(11) **EP 4 556 926 B1**

(12) **EUROPÄISCHE PATENTSCHRIFT**

(45) Veröffentlichungstag und Bekanntmachung des Hinweises auf die Patenterteilung:
**26.08.2026 Patentblatt 2026/35**

(21) Anmeldenummer: **23210639.3**

(22) Anmeldetag: **17.11.2023**

(51) Internationale Patentklassifikation (IPC):
***G01R 31/55*** (2020.01) ***G01R 31/58*** (2020.01)
***G01R 31/66*** (2020.01)

(52) Gemeinsame Patentklassifikation (CPC):
**G01R 31/55; G01R 31/58; G01R 31/66**

(54) **VERFAHREN ZUM PRÜFEN EINER VERDRAHTUNG EINER ELEKTRISCHEN ANLAGE**

METHOD FOR TESTING A WIRING OF AN ELECTRICAL INSTALLATION

PROCÉDÉ DE CONTRÔLE DU CÂBLAGE D’UNE INSTALLATION ÉLECTRIQUE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(43) Veröffentlichungstag der Anmeldung:
**21.05.2025 Patentblatt 2025/21**

(73) Patentinhaber: **Omicron electronics GmbH**
**6833 Klaus (AT)**

(72) Erfinder: **SCHMIDBAUER, Josef**
**5020 Salzburg (AT)**

(74) Vertreter: **Kraus & Lederer PartGmbB**
**Thomas-Wimmer-Ring 15**
**80539 München (DE)**

(56) Entgegenhaltungen:
**JP-A- 2020 143 913** **JP-A- 2023 096 699**
**JP-B2- 6 587 073**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 4 556 926 B1

## Beschreibung

### GEBIET DER ERFINDUNG

Die vorliegende Erfindung betrifft Verfahren zum Prüfen einer Verdrahtung einer elektrischen Anlage, insbesondere zum Prüfen einer Verdrahtung einer elektrischen Anlage mit mehreren Stromkreisen, beispielsweise eine energietechnische elektrische Anlage in beispielsweise einem Umspannwerk oder einem Kraftwerk.

### HINTERGRUND

Bei einer Installation, Reparatur oder Erweiterung einer elektrischen Anlage, beispielsweise in einem Umspannwerk oder einem Kraftwerk, können Verdrahtungsfehler auftreten. Insbesondere bei Anlagen mit mehreren Stromkreisen und/oder mehreren Phasen, beispielsweise Anlagen für dreiphasigen Wechselstrom, können Leiter vertauscht werden, beispielsweise können zwei Außenleiter vertauscht werden oder ein Außenleiter mit dem Neutralleiter. Weiterhin kann beispielsweise beim Anschluss eines Transformators eine Polarität vertauscht werden. Vor einer Inbetriebnahme oder einer Wiederinbetriebnahme einer elektrischen Anlage wird daher üblicherweise eine Prüfung der Verdrahtung durchgeführt, um falsch angeschlossene Leiter und vertauschte Polaritäten festzustellen.

Beispielsweise können Prüfsignale nacheinander in die einzelnen Phasen an einer Einspeisestelle eingespeist werden und an einer davon entfernten Messstelle, an welcher gemäß Soll-Verdrahtung eine Wirkung des Prüfsignals auftreten sollte, ein Messsignal erfasst werden. Wird an der Messstelle nicht die erwartete Wirkung des Prüfsignals erfasst, könnte ein Verdrahtungsfehler vorliegen. Diese Vorgehensweise ist verhältnismäßig aufwändig, da zum Überprüfen mehrerer Stromkreise und Phasen etliche Messungen durchzuführen sind und das Messgerät für jede Messung entsprechend an der Einspeisestelle und der Messstelle anzuschließen ist. Ferner kann mit einer derartigen Messung zwar festgestellt werden, dass ein Verdrahtungsfehler vorliegt, es ist jedoch nicht unmittelbar möglich, festzustellen, welcher Art der Verdrahtungsfehler ist, ob beispielsweise Leiter vertauscht oder nicht angeschlossen sind.

Auch eine richtige Polarität eines Strom- und Spannungswandler ist zu überprüfen. Eine falsche Polarität kann beispielsweise zu einer Fehlfunktion eines Schutzrelais führen. In Messkreisen kann eine falsche Polarität zu einer scheinbar entgegengesetzten Richtung des Stromflusses und damit zu falschen Messergebnissen führen. Bei diesen Funktionen ist es auch wichtig, die richtige Phasenzuordnung vom Messwandler zum Schutzrelais oder Zähler zu überprüfen.

Für die Prüfung der Polarität gibt es weitere Methoden. Sie können auch verwendet werden, um die korrekte Phasenzuordnung zu überprüfen, indem man Phase für Phase vorgeht und prüft, ob die erwartete Reaktion auf der zu prüfenden Phase eintritt.

Zum Beispiel kann eine DC-Spannungsprüfung durchgeführt werden. Bei dieser Prüfung wird eine Batterie kurzzeitig an eine Seite des Messwandlers angeschlossen und der kurzzeitige Ausschlag eines an die andere Seite angeschlossenen Milliampermeters oder Millivoltmeters aufgezeichnet. Der bei dieser Prüfung fließende Gleichstrom könnte den Messwandler magnetisieren. Die daraus resultierende Sättigung kann zu Fehlfunktionen des Schutzsystems führen. Daher ist es wichtig, jeden Stromwandler, der mit dieser Methode geprüft wird, nach der Prüfung zu entmagnetisieren. Mit dieser Methode können die Polarität und die Phasenzuordnung entlang der Sekundärverdrahtung überprüft werden. Dies erfordert jedoch eine Person, die den Batterieschalter bedient, und eine weitere Person, die die Messung an einem anderen Ort genau zur gleichen Zeit durchführt.

In anderen Beispielen kann eine Wechselspannungsprüfung mit Phasenvergleich durchgeführt werden. Bei dieser Prüfung wird eine Wechselspannung oder ein Wechselstrom an eine Seite des Messwandlers angelegt und die Phase der Spannung oder des Stroms auf der anderen Seite bestimmt, z.B. mit einem Oszilloskop, einem speziellen Phasenmessgerät oder einem Relaisprüfgerät mit dieser Funktion. Zeigt der Phasenvergleich ca. 0°, ist die Polarität richtig, bei ca. 180° ist die Polarität invertiert. Kann das erwartete Signal an einem bestimmten Prüfpunkt nicht gemessen werden, deutet dies in der Regel auf ein Verdrahtungsproblem hin. Der Phasenvergleich kann einfach direkt am Messwandler durchgeführt werden. Für die Prüfung der Sekundärwicklung zum Relais oder Zähler muss am jeweiligen Messort die gleiche Wechselspannungsreferenz zur Verfügung stehen. Dazu wird entweder ein separates Kabel mit der Wechselspannungsreferenz zur Messstelle verlegt oder eine gemeinsame Referenz, wie die Netzwechselspannung, verwendet. Im zweiten Fall ist darauf zu achten, dass an allen Messstellen die gleiche Phase der Netzspannung zur Verfügung steht.

Viele energietechnische Systeme verwenden ein drei Phasen Drehstromsystem.

Ebenso besitzen viele Prüfgeräte mindestens drei Strom- oder Spannungsausgänge. Mithilfe dieser Prüfgeräte können daher Prüfsignale parallel eingespeist werden und die Verdrahtung aller Phasen in einem Arbeitsgang geprüft werden. Dazu kann beispielsweise ein Prüfsignal mit unterschiedlichen Amplituden für die verschiedenen Phasen verwendet werden. Insbesondere können dabei Amplituden für Ströme und Spannungen verwendet werden, deren Kombination und/oder Subtraktion neue Amplituden ergeben, die sonst nicht vorkommen.

Beispiel:

| | | | |
|---|---|---|---|
| L1 = 3 | L1 + L2 = 8 | L1 - L2 = - 2 | L1+L2+L3 = 17 |
| L2 = 5 | L1 + L3 = 12 | L1 - L3 = - 6 | L1+L2-L3 = -1 |
| L3 = 9 | L2 + L3 = 14 | L2 - L3 = - 4 | L1-L2+L3 = 7 |
| | | | -L1+L2+L3 = 11 |

Damit lassen sich Verdrahtungsfehler aufgrund der gemessenen Amplitude erkennen, z.B. wenn der Rückleiter einer Phase falsch angeschlossen ist.

Die Strom- oder Spannungsamplituden müssen sich jedoch relativ stark unterscheiden, um eine eindeutige Zuordnung durchführen zu können. Daher kann nicht immer mit Amplituden in der Nähe des Nominalbereichs der Betriebsmittel (z.B. 1A, 5A oder 100V) gearbeitet werden. Weiterhin kommt in der Praxis häufig vor, dass mehrere parallele Verbindungen oder Erdverbindungen bestehen. In diesen Fällen erfolgt eine Stromaufteilung oder Spannungsteilung abhängig von den jeweiligen Widerständen. Eine Phasenerkennung ist dann nicht mehr eindeutig möglich.

Die Druckschrift JP 2023 096699 A offenbart ein Verfahren zum Prüfen einer Verdrahtung einer elektrischen Anlage wobei die Prüfsignale lediglich in einen einzigen Anschluss eingespeist werden. Jedes Prüfsignal besteht aus einer einzelnen höheren Harmonischen eines Referenzsignals.

## ZUSAMMENFASSUNG DER ERFINDUNG

Es besteht ein Bedarf an verbesserten Möglichkeiten zum Prüfen einer Verdrahtung einer elektrischen Anlage mit mehreren Stromkreisen, welche schnell und zuverlässig mit einfachen Mitteln durchgeführt werden können.

Gemäß der vorliegenden Erfindung werden ein Verfahren zum Prüfen einer Verdrahtung einer elektrischen Anlage mit mehreren Stromkreisen und eine Prüfvorrichtung zum Prüfen einer Verdrahtung einer elektrischen Anlage mit mehreren Stromkreisen bereitgestellt, wie sie in den unabhängigen Ansprüchen definiert sind. Die abhängigen Ansprüche definieren Ausführungsformen der Erfindung.

Ein erfindungsgemäßes Verfahren zum Prüfen einer Verdrahtung einer elektrischen Anlage mit mehreren Stromkreisen umfasst ein Erzeugen mehrerer Prüfsignale. Jedes der mehreren Prüfsignale weist eine Kombination von vorgegebenen Harmonischen mit mindestens einer, vorzugsweise mindestens zwei höheren Harmonischen auf. Amplitude und/oder Phasenlage (nachfolgend häufig kurz "Phase" genannt) der mindestens einen höheren Harmonischen der mehreren Prüfsignale sind unterschiedlich.

Anders ausgedrückt umfasst jedes der mehreren Prüfsignale eine Kombination von vorgegebenen Harmonischen. Mindestens eine höhere Harmonische dieser vorgegebenen Harmonischen wird bei einem jeweiligen der mehreren Prüfsignale in Bezug auf Phase und/oder Amplitude jeweils anders variiert. Somit besitzt jedes Prüfsignal eine eigene eindeutige Kombination von Amplitude und Phase bei der mindestens einen Harmonischen.

Zum Beispiel umfasst jedes der mehreren Prüfsignale eine oder mehrere Harmonische, die bei jedem der mehreren Prüfsignale gleich sind (insbesondere auch in Bezug auf Phase und Amplitude). Ferner umfasst jedes der Prüfsignale mindestens eine weitere höhere Harmonische. Diese mindestens eine weitere höhere Harmonische hat für jedes der mehreren Prüfsignale eine bestimmte Variation von Phase und/oder Amplitude. Phase und/oder Amplitude dieser mindestens einen weiteren höheren Harmonischen sind bei den verschiedenen Prüfsignalen somit unterschiedlich.

Zum Beispiel können bei jedem der mehreren Prüfsignale die erste, zweite und dritte Harmonische gleich sein und die vierte und fünfte Harmonische, welche in diesem Beispiel der mindestens einen höheren Harmonischen entsprechen, können bei den verschiedenen Prüfsignalen unterschiedliche Phasen und/oder Amplituden aufweisen. Bei einem einfachen Beispiel kann jedes Prüfsignal eine erste Harmonische und eine zweite Harmonische umfassen. Die erste Harmonische ist bei allen Prüfsignalen gleich und die zweite Harmonische hat bei den verschiedenen Prüfsignalen verschiedene Phasen.

Für diese Beschreibung gelten folgende Bezeichnungen. Eine Grundschwingung der Frequenz f wird als erste Harmonische bezeichnet. Eine Schwingung der doppelten Frequenz (2f) wird als zweite Harmonische bezeichnet. Allgemein ist die Schwingung mit der n-fachen Frequenz nf die n-te Harmonische. Als höhere Harmonische werden alle Harmonischen außer der ersten Harmonischen bezeichnet. Höhere Harmonische werden auch als Oberschwingungen bezeichnet. Die n-te Harmonische wird dabei als die (n-1)-te Oberschwingung bezeichnet.

Der Begriff "Phase" hat in dieser Beschreibung folgende Bedeutungen. Zum einen wird er im Zusammenhang mit einem Mehrphasenwechselstrom verwendet. Beispielsweise wird in der Elektrotechnik eine Form von Mehrphasenwechselstrom als ein Dreiphasenwechselstrom benannt, die aus drei einzelnen Wechselströmen oder Wechselspannungen gleicher Frequenz besteht, die zueinander in ihren Phasenwinkeln fest um 120° verschoben sind. Jedem dieser einzelnen Wechselströme bzw. jeder dieser einzelnen Wechselspannungen können Komponenten einer mehr-

phasigen elektrischen Anlage zugeordnet sein, beispielsweise ein Leiter eines Energieübertragungskabels oder eine Wicklung eines Transformators oder Generators. Dadurch kann die mehrphasige elektrische Anlage mehrere miteinander gekoppelte Stromkreise aufweisen, die als Phasen bezeichnet werden.

Zum anderen wird der Begriff "Phase" in dieser Beschreibung auch verwendet, um die Phasenlage von periodischen Signalen zueinander innerhalb eines elektrischen Signals zu beschreiben. Beispielsweise kann ein elektrisches Signal, beispielsweise eine elektrische Spannung, eine Sinusschwingung mit 50 Hz und eine Sinusschwingung mit 100 Hz umfassen. Die Phasenlage, oder kurz "Phase", beschreibt den Phasenwinkel zwischen den Nulldurchgängen dieser Schwingungen.

Jedes der mehreren Prüfsignale kann eine im Zeitbereich asymmetrische Signalform aufweisen. Die im Zeitbereich asymmetrische Signalform umfasst eine erste Harmonische (Grundschwingung). Die Signalform ist periodisch mit der Frequenz dieser Grundschwingung. Im Zeitbereich asymmetrisch bedeutet, dass die Signalform, die als Signalpegel über der Zeit aufgetragen wird, durch Spiegeln an einer Signalpegel-Achse senkrecht zur Zeitachse nicht auf sich selbst abgebildet werden kann. Ein Beispiel für eine derartige im Zeitbereich asymmetrische Signalform ist die Kippschwingung oder Sägezahnschwingung mit beispielsweise einer steigenden Flanke mit kleiner Steigung und einer fallenden Flanke mit betragsmäßig großer (aber negativer) Steigung.

Beispielsweise kann jedes der mehreren Prüfsignale eine im Zeitbereich asymmetrische Signalform aufweisen, welche mittels einer Überlagerung einer ersten Harmonischen, einer zweiten Harmonischen und einer dritten Harmonischen mit jeweils entsprechenden Amplitudenfaktoren gebildet wird. Die im Zeitbereich asymmetrische Signalform umfasst in diesem Fall beispielsweise zusätzlich zu einer Grundschwingung zumindest eine zweite und dritte Harmonische. In einem anderen Beispiel kann die im Zeitbereich asymmetrische Signalform zusätzlich zu der Grundschwingung lediglich entweder die zweite oder die dritte Harmonische umfassen. Die mindestens eine höhere Harmonische kann beispielsweise zwei höhere Harmonische umfassen, nämlich eine vierte Harmonische und eine fünfte Harmonische, wobei sich die vierte und fünfte Harmonische bei den verschiedenen Prüfsignalen durch Amplitude und/oder Phase unterscheiden. Der aus Grundschwingung und zweiten und dritten Harmonischen gebildeten im Zeitbereich asymmetrischen Signalform können die vierte und fünfte Harmonische mit den unterschiedlichen Amplituden und/oder Phasen überlagert werden. Beispielsweise kann ein erstes Prüfsignal der mehreren Prüfsignale zusätzlich zu der Grundschwingung und der zweiten und dritten Harmonischen eine vierte Harmonische mit einem Amplitudenfaktor von 1,35/16 und einem Phasenversatz von +30° bezogen auf eine Amplitude bzw. Phase der Grundschwingung und eine fünfte Harmonische mit einem Amplitudenfaktor von 1/25 und einem Phasenversatz von -30° bezogen auf eine Amplitude bzw. Phase der Grundschwingung aufweisen. Ein zweites Prüfsignal der mehreren Prüfsignale kann zusätzlich zu der Grundschwingung und der zweiten und dritten Harmonischen eine vierte Harmonische mit einem Amplitudenfaktor von 1/16 und einem Phasenversatz von -30° bezogen auf eine Amplitude bzw. Phase der Grundschwingung und eine fünfte Harmonische mit einem Amplitudenfaktor von 0,5/25 und einem Phasenversatz von -30° bezogen auf eine Amplitude bzw. Phase der Grundschwingung aufweisen. Ein drittes Prüfsignal der mehreren Prüfsignale kann zusätzlich zu der Grundschwingung und der zweiten und dritten Harmonischen eine vierte Harmonische mit einem Amplitudenfaktor von 1/16 und einem Phasenversatz von 0° (also ohne Phasenversatz) bezogen auf eine Amplitude bzw. Phase der Grundschwingung und eine fünfte Harmonische mit einem Amplitudenfaktor von 0,5/25 und einem Phasenversatz von -30° bezogen auf eine Amplitude bzw. Phase der Grundschwingung aufweisen. Wichtig ist in dem obigen Beispiel, dass sich die Prüfsignale zumindest in einer von der vierten und fünften Harmonischen zumindest über die Amplitude oder die Phase voneinander unterscheiden. Prinzipiell genügt es beispielsweise auch, wenn sich die Prüfsignale beispielsweise nur in der vierten Harmonischen über die Phase voneinander unterscheiden. Je deutlicher die Prüfsignale sich voneinander unterscheiden, beispielsweise durch unterschiedliche Phasen und Amplituden in sowohl der vierten als auch fünften Harmonischen, umso sicherer können die Prüfsignale identifiziert werden, wie es bei dem Verfahren wichtig ist, wie nachfolgend erläutert werden wird.

Insgesamt ist beispielsweise die Kombination der Harmonischen der mehreren Prüfsignale derart ausgestaltet, dass auch beliebige Linearkombinationen der mehreren Prüfsignale im Wesentlichen die gleichen Eigenschaften im Zeitbereich wie die einzelnen Prüfsignale aufweisen. Dies kann zum Beispiel erreicht werden, indem sich die Prüfsignale lediglich durch die höheren Harmonischen (z.B. der vierten und fünften Harmonischen) unterscheiden und bezüglich der Grundschwingung phasensynchron sind. Bei einer entsprechenden Veränderung der höheren Harmonischen (z.B. Phase und/oder Amplitude der vierten und fünften Harmonischen) kann auch erkannt werden, welche Einzelsignale in einem Summensignal, also der Linearkombination, vorkommen. Somit können die einzelnen Signale erkannt werden, aber auch beim Summensignal einfach festgestellt werden, aus welchen Teilsignalen es besteht.

Die so erzeugten mehreren Prüfsignale werden über mehrere erste Anschlüsse, die den mehreren Stromkreisen der elektrischen Anlage zugeordnet sind, an einer ersten Stelle der elektrischen Anlage eingespeist. Die mehreren Stromkreise können beispielsweise mehrere Phasen der elektrischen Anlage umfassen. In jeden ersten Anschluss der mehreren ersten Anschlüsse wird ein anderes Prüfsignal der mehreren Prüfsignale eingespeist. Anders ausgedrückt wird an der ersten Stelle in jeden Stromkreis der elektrischen Anlage ein anderes Prüfsignal eingespeist.

An einer zweiten Stelle der elektrischen Anlage können mehrere Messsignale an mehreren zweiten Anschlüs-

sen, die den mehreren Stromkreisen zugeordnet sind, erfasst werden. Beispielsweise kann bei einem Umspannwerk die erste Stelle an einem Eingang des Umspannwerks sein und die zweite Stelle an einem der Ausgänge des Umspannwerks. In einem anderen Beispiel kann die erste Stelle an einer ersten Seite eines Transformators sein und die zweite Stelle an einer zweiten Seite des Transformators. Auf der Grundlage der eingespeisten Prüfsignale und der erfassten Messsignale kann eine Zuordnung zwischen jeweils einem ersten Anschluss der mehreren ersten Anschlüsse und einem zweiten Anschluss der mehreren zweiten Anschlüsse bestimmt werden, um beispielsweise abhängig von den Zuordnungen die Verdrahtung der elektrischen Anlage zu prüfen. Da die eingespeisten Prüfsignale unterschiedlich sind, kann eindeutig festgestellt werden, welches Prüfsignal an welchem der zweiten Anschlüsse zu einem entsprechenden Messsignal geführt hat, sodass eine eindeutige Zuordnung zwischen den ersten Anschlüssen und den zweiten Anschlüssen bestimmt werden kann. Beispielsweise können Vertauschungen, aber auch Unterbrechungen, auf einfache Art und Weise anhand der Prüfsignale festgestellt werden.

Beispielsweise kann im Falle eines Verdrahtungsfehlers eine Zuordnung ermittelt werden, die nicht einer gewünschten oder vorgegebenen Zuordnung entspricht, oder es ist keine oder keine vollständige Zuordnung möglich, zum Beispiel aufgrund von Unterbrechungen oder Kopplungen mit gänzlich falschen Stromkreisen. Im fehlerfreien Fall kann hingegen eine Zuordnung ermittelt werden, die einer vorgegebenen "Soll-Zuordnung" entspricht.

Durch die unterschiedlichen Phasen und/oder Amplituden der mindestens einen höheren Harmonischen der verschiedenen Prüfsignale, beispielsweise durch die unterschiedlichen Phasen und/oder Amplituden der vierten und fünften Harmonischen bei den verschiedenen Prüfsignalen, erfolgt somit eine eindeutige Kennzeichnung der Prüfsignale. Durch Hinzuziehen einer weiteren Harmonischen, beispielsweise der sechsten Harmonischen kann die Anzahl der unterschiedlichen Kennzeichnungen und somit die Anzahl der unterschiedlichen Prüfsignale erhöht werden, um beispielsweise Prüfsignale zum Prüfen einer Verdrahtung einer elektrischen Anlage mit mehr als drei Phasen oder Stromkreisen zu ermöglichen, beispielsweise zum Prüfen von zwei dreiphasigen Anlagenteilen, also insgesamt sechs Phasen, oder Anlagenteilen mit mehreren Stromkreisen, beispielsweise mit sechs oder mehr Stromkreisen. Prinzipiell genügt es jedoch auch, wenn nur eine höhere Harmonische unterschiedliche Phasen und/oder Amplituden bei verschiedenen Prüfsignalen aufweist. Wenn beispielsweise drei unterschiedliche Phasen und drei unterschiedliche Amplituden bei der vierten Harmonischen verwendet werden, können bereits neun unterschiedliche Prüfsignale erzeugt werden. In einem anderen Beispiel werden lediglich drei unterschiedliche Phasen bei der vierten Harmonischen verwendet, womit bereits drei unterschiedliche Prüfsignale erzeugt werden können. Je mehr Unterscheidungsmerkmale jedoch vorhanden sind, umso besser können die unterschiedlichen Prüfsignale voneinander unterschieden werden.

Die mehreren Prüfsignale können gleichzeitig in die mehreren ersten Anschlüsse eingespeist werden. Ebenso können die mehreren Messsignale gleichzeitig erfasst werden. Durch die Kennzeichnung der Prüfsignale aufgrund der unterschiedlichen Phasen und/oder Amplituden von bestimmten Harmonischen, können die mehreren Messsignale, welche an der zweiten Stelle der elektrischen Anlage erfasst werden, den entsprechenden Prüfsignalen eindeutig zugeordnet werden, auch wenn die Prüfsignale gleichzeitig durch die elektrische Anlage geleitet werden. Eine entsprechende Messverkabelung zum Einspeisen der Prüfsignale und zum Erfassen der Messsignale kann daher zu einem Zeitpunkt erfolgen und die Verdrahtung überprüft werden, ohne die Messverkabelung zu ändern. Dadurch kann die Prüfung der Verdrahtung schnell durchgeführt werden. Verkabelungsfehler können vermieden werden, da die Messverkabelung nicht geändert werden muss, um die Verdrahtung aller Stromkreise und/oder Phasen zu überprüfen.

Gemäß einer Ausführungsform weist die erste Harmonische, also die Grundschwingung, eine Frequenz auf, welche ungleich einer Netzfrequenz oder Nominalfrequenz der elektrischen Anlage ist. Die erste Harmonische kann beispielsweise eine Frequenz im Bereich von 50 bis 60 Hz aufweisen, insbesondere eine Frequenz im Bereich von 51 bis 55 Hz, beispielsweise eine Frequenz von 52,6 Hz. Indem die erste Harmonische der Prüfsignale ungleich der Netzfrequenz der elektrischen Anlage ist, können Störungen von anderen in Betrieb befindlichen Anlagenteilen vermieden werden. In Betrieb befindliche Anlagenteile erzeugen üblicherweise Störsignale bei Netzfrequenz, also beispielsweise bei 50 Hz oder 60 Hz, sowie Störsignale mit höheren Harmonischen davon. Wenn die Grundschwingung und die höheren Harmonischen der Prüfsignale von dieser Netzfrequenz und den entsprechenden höheren Harmonischen abweichen, können die Störsignale von anderen in Betrieb befindlichen Anlagenteilen auf einfache Art und Weise in den Messsignalen erkannt und herausgefiltert werden. Da die Grundschwingung eine Frequenz hat, die nicht sehr stark von der Nominalfrequenz der elektrischen Anlage abweicht, sind die Prüfsignale für eine Übertragung über die elektrische Anlage geeignet, beispielsweise über Strom- oder Spannungswandler mit Transformatoren und/oder Kapazitäten.

Bei einer Ausführungsform weist eine Amplitude einer n-ten Harmonischen der höheren Harmonischen, bei denen die Phase und/oder Amplitude nicht zur Kennzeichnung verwendet wird, einen Amplitudenfaktor von $1/n^2$ bezogen auf eine Amplitude der Grundschwingung auf. Zum Beispiel können die oben beschriebenen zweiten und dritten Harmonischen einen entsprechenden Amplitudenfaktor aufweisen. Mit derartigen Amplitudenfaktoren kann die im Zeitbereich asymmetrische Signalform erreicht werden. Signalformen, welche die erste bis dritte Harmonische mit einem Amplitudenfaktor von $1/n^2$ umfassen, weisen beispielsweise eine Sägezahn-ähnliche Signalform mit einer steilen steigenden Flanke und einer flachen fallenden Flanke auf, sodass die Signalform im Zeitbereich asymmetrische ist. Ferner haben die so erzeugten Prüfsignale im Wesentlichen im Mittel keinen Gleichanteil, sodass eine Sättigung von

Strom- oder Spannungswandlern in der elektrischen Anlage vermieden werden kann. Die Sägezahn-ähnliche Signalform bleibt im Wesentlichen auch erhalten, wenn zusätzlich die mindestens eine höhere Harmonische mit geänderter Amplitude und/oder Phase überlagert wird, sofern die Amplitude in der Größenordnung von $1/n^2$ ist, z.B. $1,5/n^2$ oder $0,5/n^2$.

Gemäß einer Ausführungsform werden die Zuordnungen bestimmt, indem Amplituden und Phasen von Spektralkomponenten für Frequenzen der Harmonischen in den Messsignalen bestimmt werden. Die Amplituden und Phasen der Spektralkomponenten werden mit Amplitudenschwellenwerten bzw. Phasenschwellenwerten verglichen. Die Amplitudenschwellenwerten können in Abhängigkeit von einer Amplitude einer Grundschwingung eingestellt werden. Die Amplitude und/oder Phasenlagen der Grundschwingung kann aus dem Messsignal bestimmt werden.

Bei einer Ausführungsform umfasst die mindestens eine höhere Harmonische vierte und fünfte Harmonische. Die vierte Harmonische weist einen Amplitudenfaktor von 1,35/16 oder 1/16 oder 0,65/16, und die fünfte Harmonische einen Amplitudenfaktor von 1,5/25 oder 1/25 oder 0,5/25 bezogen auf eine Amplitude der Grundschwingung auf. Wie zuvor bereits erörtert, kann eine Amplitude einer der übrigen n-ten höheren Harmonischen der vorgegebenen Harmonischen einen Amplitudenfaktor von 1/n2 bezogen auf eine Amplitude der Grundschwingung aufweisen.

Die vierte Harmonische kann beispielsweise einen Phasenversatz von +30° oder 0° oder -30°, und die fünfte Harmonische einen Phasenversatz von +30° oder 0° oder -30° bezogen auf eine Phase der Grundschwingung aufweisen. In anderen Beispielen kann der Phasenversatz der vierten oder fünften Harmonischen beispielsweise +20° oder 0° oder -20° bezogen auf eine Phase der Grundschwingung aufweisen. Der Phasenversatz kann beispielsweise im Bereich von +/-90°, vorzugsweise im Bereich von +/-45, weiter vorzugsweise im Bereich von +/-30° bezogen auf eine Phase der Grundschwingung gewählt werden.

Gemäß einer weiteren Ausführungsform umfasst das Verfahren weiterhin ein Bestimmen von Polaritäten der erfassten Messsignale, um abhängig von den bestimmten Polaritäten die Verdrahtung der elektrischen Anlage zu prüfen. Insbesondere die asymmetrische Signalform der Prüfsignale im Zeitbereich kann eine einfache und zuverlässige Bestimmung der Polarität ermöglichen. Wenn beispielsweise die Verdrahtung eines Transformators fehlerhaft ist, zum Beispiel wenn Anschlüsse an einer Seite des Transformators vertauscht wurden, kann das Messsignal eine gegenüber dem entsprechenden Prüfsignale entgegengesetzte Polarität aufweisen. Bei einer im Zeitbereich asymmetrischen Signalform kann die entgegengesetzte Polarität leicht erkannt werden. Hat beispielsweise das Prüfsignal eine steile steigende Flanke und eine flache fallende Flanke, hat ein Messsignal mit entgegengesetzter Polarität eine flache steigende Flanke und eine steile fallende Flanke. Ein entsprechender Fehler in der Verdrahtung kann somit festgestellt werden.

Zum Bestimmen von Polaritäten der erfassten Messsignale kann beispielsweise für ein jeweiliges Messsignalen der erfassten Messsignale eine Ableitung des Messsignals bestimmt werden und ein Vergleichssignal durch Vergleichen der Ableitung mit einem Schwellenwert erzeugt werden. Das Vergleichssignal kann beispielsweise einen positiven Wert für Bereiche der Ableitung mit positiver Steigung über dem Schwellenwert und einen betragsmäßig gleichen negativen Wert für Bereiche der Ableitung mit negativer Steigung über dem Schwellenwert aufweisen. Wird dann der Mittelwert des Vergleichssignals bestimmt, beispielsweise als gleitender Mittelwert oder über eine Periode der Grundschwingung des Prüfsignals, kann die Polarität des Messsignals in Abhängigkeit von dem Mittelwert des Vergleichssignals bestimmt werden.

Alternativ oder zusätzlich kann das Bestimmen von Polaritäten der erfassten Messsignale für ein jeweiliges Messsignalen ein Bestimmen eines Korrelationskoeffizienten, insbesondere eines Korrelationsfaktors, in Abhängigkeit von dem jeweiligen Messsignal und der im Zeitbereich asymmetrischen Signalform umfassen. Die Polarität des jeweiligen Messsignals kann in Abhängigkeit von dem Korrelationsfaktor bestimmt werden. Bei gleicher Polarität ist der Korrelationsfaktor positiv und hat beispielsweise einen Wert nahe 1. Bei entgegengesetzter Polarität ist der Korrelationsfaktor negativ und hat beispielsweise einen Wert nahe -1.

Eine erfindungsgemäße Prüfvorrichtung zum Prüfen einer Verdrahtung einer elektrischen Anlage mit mehreren Stromkreisen umfasst eine Prüfsignalerzeugungsvorrichtung und eine Einspeisevorrichtung. Die Prüfsignalerzeugungsvorrichtung ist ausgestaltet, mehrere Prüfsignale zu erzeugen. Jedes der mehreren Prüfsignale weist eine Kombination von Harmonischen mit mindestens einer höheren Harmonischen auf. Amplitude und/oder Phase der mindestens einen höheren Harmonischen sind bei den mehreren Prüfsignalen unterschiedlich. Die Einspeisevorrichtung ist ausgestaltet, an einer ersten Stelle der elektrischen Anlage die mehreren Prüfsignale in mehrere erste Anschlüsse einzuspeisen. Die mehreren ersten Anschlüsse sind den mehreren Stromkreisen der elektrischen Anlage zugeordnet. In jeden ersten Anschluss der mehreren ersten Anschlüsse wird ein anderes Prüfsignal der mehreren Prüfsignale eingespeist. Da die Prüfsignale auf unterschiedlichen Kombinationen von Harmonischen beruhen, sind die an der ersten Stelle in die mehreren ersten Anschlüsse eingespeisten Prüfsignale unterschiedlich.

Die Prüfvorrichtung kann in einigen Ausführungsbeispielen ferner eine Erfassungsvorrichtung und eine Verarbeitungsvorrichtung umfassen. Die Erfassungsvorrichtung ist ausgestaltet, an einer zweiten Stelle der elektrischen Anlage mehrere Messsignale an mehreren zweiten Anschlüssen, die den mehreren Stromkreisen zugeordnet sind, zu erfassen. Die erste Stelle und die zweite Stelle sind unterschiedliche Stellen der elektrischen Anlage. Die mehreren Stromkreise können beispielsweise mehrere Phasen der elektrischen Anlage umfassen. Beispielsweise kann die erste

Stelle an einer Seite eines Transformators der elektrischen Anlage sein und die zweite Stelle an der anderen Seite des Transformators. Die Erfassungsvorrichtung ist ausgestaltet, Zuordnungen zwischen jeweils einem ersten Anschluss der mehreren ersten Anschlüsse und einem zweiten Anschluss der mehreren zweiten Anschlüsse auf der Grundlage der eingespeisten Prüfsignale und der erfassten Messsignale zu bestimmen.

Die Prüfsignalerzeugungsvorrichtung kann mehrere einphasige Geräte umfassen, die jeweils nur ein Prüfsignal erzeugen. Die mehreren einphasigen Geräte können so konfiguriert werden, dass sie jeweils eines der mehreren Prüfsignale erzeugen, die auf unterschiedlichen Amplituden und/oder Phasen der mindestens einen höheren Harmonischen beruhen. Alternativ oder zusätzlich kann die Prüfsignalerzeugungsvorrichtung mehrere mehrphasige Geräte umfassen, zum Beispiel zwei dreiphasige Geräte, um sechs Prüfsignale erzeugen, mit denen sechs Stromkreise oder Phasen gleichzeitig geprüft werden können. Die Geräte können dabei in Verbindung stehen sein, um die gleiche Phasenlage für die Grundschwingungen zu erreichen, was die Erkennung von überlagerten Signalen vereinfacht. Die Erkennung der einzelnen Phasen funktioniert aber auch, wenn die Geräte nicht gekoppelt sind.

Die Prüfvorrichtung kann insbesondere zur Durchführung des zuvor beschriebenen Verfahrens oder einer seiner Ausführungsformen ausgestaltet sein und umfasst daher auch die im Zusammenhang mit dem Verfahren zuvor beschriebenen Vorteile.

## KURZE BESCHREIBUNG DER FIGUREN

Die Erfindung wird nachfolgend unter Bezugnahme auf die Zeichnungen anhand von Ausführungsformen näher erläutert. In den Zeichnungen bezeichnen identische Bezugszeichen identische Elemente.

Fig. 1 zeigt schematisch eine Prüfvorrichtung zum Prüfen einer Verdrahtung einer elektrischen Anlage mit mehreren Phasen gemäß einer Ausführungsform.

Fig. 2 zeigt ein Verfahren zum Prüfen einer Verdrahtung einer elektrischen Anlage mit mehreren Phasen gemäß einer Ausführungsform.

Fig. 3 zeigt schematisch mehrere Prüfsignale gemäß einer Ausführungsform, die eine im Zeitbereich asymmetrische Signalform und eine Kombination von höheren Harmonischen aufweisen.

Fig. 4 zeigt schematisch Ableitungen der mehreren Prüfsignale der Fig. 3 nach der Zeit.

Fig. 5 zeigt schematisch ein Vergleichssignal, welches durch Vergleichen einer Ableitung eines Prüfsignals mit einem Schwellenwert gebildet wird.

Fig. 6 zeigt schematisch eine weitere Prüfvorrichtung zum Prüfen einer Verdrahtung einer elektrischen Anlage mit mehreren Stromkreisen gemäß einer Ausführungsform.

## DETAILLIERTE BESCHREIBUNG VON AUSFÜHRUNGSBEISPIELEN

Nachfolgend wird die vorliegende Erfindung anhand von Ausführungsformen unter Bezugnahme auf die Figuren näher erläutert. In den Figuren bezeichnen gleiche Bezugszeichen gleiche oder ähnliche Elemente. Die Figuren sind schematische Darstellungen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und ihr Zweck dem Fachmann verständlich werden.

In den Figuren dargestellte Verbindungen und Kopplungen zwischen funktionellen Einheiten und Elementen können als direkte oder indirekte Verbindungen oder Kopplungen implementiert werden. Eine Verbindung oder Kopplung kann drahtgebunden oder drahtlos implementiert sein.

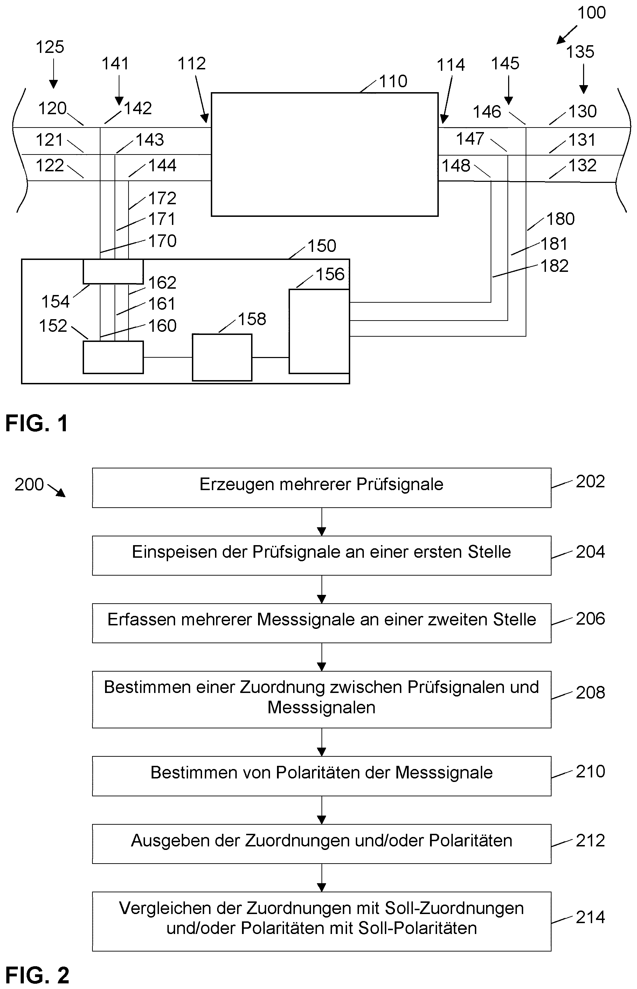

Fig. 1 zeigt schematisch einen Ausschnitt einer elektrischen Anlage 100, an welche eine Prüfvorrichtung 150 zum Prüfen einer Verdrahtung der elektrischen Anlage 100 angeschlossen ist. Die elektrische Anlage 100 ist eine mehrphasige elektrische Anlage. Viele energietechnische Systeme verwenden ein drei Phasen Drehstromsystem. In dem in Fig. 1 gezeigten Beispiel ist die elektrische Anlage 100 eine dreiphasige Anlage. Die elektrische Anlage 100 kann beispielsweise eine Hochspannungsanlage oder einen Teil davon umfassen. Die elektrische Anlage 100 umfasst eine elektrische Komponente 110, an welcher zwei dreiphasige Anschlüsse vorgesehen sind. Die elektrische Komponente 110 kann beispielsweise einen dreiphasigen Leistungsschalter, einen dreiphasigen Transformator, mehrere Transformatoren, Kapazitäten, Strom- und Spannungswandler oder Zwischenwandler aufweisen. An einer ersten Seite 112 weist die elektrische Komponente 110 Anschlüsse auf, die mit Außenleitern 120 bis 122 einer dreiphasigen Stromleitung 125 verbunden sind. An einer zweiten Seite 114 weist die elektrische Komponente 110 Anschlüsse auf, die mit Außenleitern

130 bis 132 einer zweiten dreiphasigen Stromleitung 135 verbunden sind. Die elektrische Komponente 110 kann weitere Anschlüsse aufweisen, beispielsweise für eine Erdung oder für einen Neutralleiter eines Dreiphasensystems in Sternschaltung, wobei jedoch diese weiteren Anschlüsse aus Gründen der Übersichtlichkeit nicht gezeigt sind. Bei einer Installation der elektrischen Komponente 110 können Verdrahtungsfehler auftreten. Beispielsweise können zwei Außenleiter, beispielsweise die Außenleiter 120 und 121, an der ersten Seite 112 der elektrischen Komponente 110 vertauscht angeschlossen sein. Nach einer Installation oder Reparatur an der elektrischen Anlage 100 kann es daher erforderlich sein, die Verdrahtung zu überprüfen.

Um die Verdrahtung zu überprüfen, kann die in Fig. 1 gezeigte Prüfvorrichtung 150 elektrisch mit beiden Seiten 112, 114 der elektrischen Komponente 110 gekoppelt werden.

Die Prüfvorrichtung 150 umfasst eine Prüfsignalerzeugungsvorrichtung 152, welche mehrere Prüfsignale erzeugt. Für eine Prüfung der dreiphasigen elektrischen Anlage 100 erzeugt die Prüfsignalerzeugungsvorrichtung 152 beispielsweise drei Prüfsignale 160 bis 162. Die Prüfvorrichtung 150 umfasst weiterhin eine Einspeisevorrichtung 154, mit welcher die Prüfsignale 160 bis 162 über entsprechende Leitungen 170 bis 172 an einer ersten Stelle 141 der elektrischen Anlage 100 in mehrere erste Anschlüsse 142 bis 144 eingespeist werden. Die Einspeisevorrichtung 154 kann beispielsweise die Prüfsignale von der Prüfsignalerzeugungsvorrichtung 152 an einen Nominalbereich der elektrischen Komponente 110 anpassen und an drei Anschlüssen bereitstellen. An die drei Anschlüsse der Einspeisevorrichtung 154 kann eine Leitungsgarnitur angeschlossen werden, welche die drei Leitungen 170 bis 172 umfasst. An der ersten Stelle 141, beispielsweise einer verhältnismäßig leicht zugänglichen Verteilung vor der elektrischen Komponente 110, kann die Leitung 170 an den Außenleiter 120 angeschlossen werden, sodass ein erstes Prüfsignal in den Außenleiter 120 eingespeist wird. Die Leitung 171 kann an den Außenleiter 121 angeschlossen werden, um ein zweites Prüfsignal in den Außenleiter 121 einzuspeisen. Die Leitung 172 kann an den Außenleiter 122 angeschlossen werden, um ein drittes Prüfsignal in den Außenleiter 122 einzuspeisen. Somit wird in jede Phase auf der ersten Seite 112 der Komponente 110 ein entsprechendes Prüfsignal eingespeist.

Die Prüfvorrichtung 150 kann weiterhin eine Erfassungsvorrichtung 156 umfassen, welche über entsprechende Leitungen 180 bis 182 mit den drei Außenleitern 130 bis 132, welche mit der zweiten Seite 114 der Komponente 110 verbunden sind, an einer zweiten Stelle 145 der elektrischen Anlage 100 über entsprechende zweite Anschlüsse 146 bis 148 verbunden ist. Die zweite Stelle 145 kann sich an einer leicht zugänglichen Verteilung der elektrischen Anlage 100 befinden. Somit kann für jede Phase auf der zweiten Seite 114 ein entsprechendes Messsignal erfasst werden.

Die Prüfvorrichtung 150 kann weiterhin eine Verarbeitungsvorrichtung 158 umfassen. Die Verarbeitungsvorrichtung 158 umfasst beispielsweise eine elektronische Steuerung, beispielsweise eine Mikroprozessorsteuerung, welche beispielsweise ein Computerprogramm ausführen kann. Die Verarbeitungsvorrichtung 158 kann mit der Prüfsignalerzeugungsvorrichtung 152 und der Erfassungsvorrichtung 156 gekoppelt sein, um diese in einer koordinierten Art und Weise anzusteuern, wie es nachfolgend im Detail beschrieben werden wird. In anderen Beispielen ist die Verarbeitungsvorrichtung 158 nicht mit der Prüfsignalerzeugungsvorrichtung 152 verbunden und die Prüfsignalerzeugungsvorrichtung 152 erzeugt die Prüfsignale unabhängig von einer Steuerung durch die Verarbeitungsvorrichtung 158. Somit ist klar, dass die Prüfsignalerzeugungsvorrichtung 152, die Einspeisevorrichtung 154, die Erfassungsvorrichtung 156 und die Verarbeitungsvorrichtung 158 nicht notwendigerweise in ein und demselben Gehäuse oder in einer Einheit ausgebildet sein müssen, sondern räumlich unabhängige Einheiten mit eigenen Gehäusen umfassen können. Beispielsweise kann die Prüfsignalerzeugungsvorrichtung 152 zusammen mit der Einspeisevorrichtung 154 eine Einheit bilden, welche unabhängig von einer weiteren Einheit betrieben und aufgestellt werden kann, welche die Erfassungsvorrichtung 156 und die Verarbeitungsvorrichtung 158 umfasst. Dadurch kann auch bei großen elektrischen Anlagen, bei denen die erste Stelle 141 räumlich weit von der zweiten Stelle 145 entfernt ist, die Prüfvorrichtung 150 verwendet werden, ohne dass entsprechend lange Leitungen 170 bis 172 bzw. 180 bis 182 erforderlich sind.

Die Arbeitsweise der Prüfvorrichtung 150 wird nachfolgend unter Bezugnahme auf die Figuren 2 bis 5 im Detail beschrieben werden. Fig. 2 zeigt ein Verfahren 200 mit Verfahrensschritten 202 bis 214, welche von der Prüfvorrichtung 150 ausgeführt werden können, um die Verdrahtung der elektrischen Anlage 100 zu prüfen. Insbesondere die Schritte 206 bis 214 können dabei optional sein oder durch andere Schritte ersetzt werden, welche auf den in den Schritten 202 und 204 erzeugten und eingespeisten Prüfsignalen beruhen. Zumindest einige der in Fig. 2 gezeigten Verarbeitungsschritte können insbesondere mit der Verarbeitungsvorrichtung 158 durchgeführt werden, beispielsweise mittels eines Computerprogramms, welches von der Verarbeitungsvorrichtung 158 ausgeführt wird.

Im Schritt 202 werden mehrere Prüfsignale erzeugt. Im Detail wird für jede Phase ein eigenes Prüfsignal $P_p(t)$ erzeugt, welches eine im Zeitbereich asymmetrische Signalform und eine Kombination von vorgegebenen Harmonischen mit mindestens einer höheren Harmonischen aufweist. Der Index $p$ bezeichnet die Phase, für die das Prüfsignal $P_p(t)$ vorgesehen ist. Die mehreren Prüfsignale unterscheiden sich dadurch voneinander, dass Amplitude und/oder Phasenlage (im Folgenden auch kurz Phase) bei der mindestens einen höheren Harmonischen unterschiedlich sind. Beispielsweise können die Prüfsignale auf einem gemeinsamen Signal $P(t)$ basieren, welches eine im Zeitbereich asymmetrische Signalform hat. Die Signalform des gemeinsamen Signals $P(t)$ kann einer Sägezahnsignalform angenähert sein. Dazu können beispielsweise Sinussignale mit verschiedener Amplitude und Frequenz verwendet werden, welche mittels

Fourier-Synthese die Sägezahnsignalform annähernd nachbilden. Beispielsweise kann als gemeinsames Signal *P(t)* ein Signal gemäß folgender Gleichung verwendet werden:

$$P(t) = A\sum_{n=1}^{k}\frac{1}{n^2}\sin(2\pi n f_g t)$$

A stellt hier die Amplitude des gesamten Signals dar, k die Anzahl der verwendeten Harmonischen und $f_g$ die Grundfrequenz des Signals. Der Term $\frac{1}{n^2}$ gewichtet die einzelnen Sinusfunktionen, um in Summe die Sägezahnsignalform anzunähern.

Beispielsweise kann ein Signal mit $A = 1$, $k = 3$ und $f_g = 52{,}6$ Hz gebildet werden. In anderen Beispielen kann A auch so gewählt werden, dass ein Effektivwert (RMS) des Signals annähernd 1 beträgt. Beispielsweise kann A ~ 0,962 gewählt werden.

Jedes der Prüfsignale $P_p(t)$ umfasst weiterhin mindestens eine höhere Harmonische, wobei Amplitude und/oder Phase dieser mindestens einen höheren Harmonischen bei den verschiedenen Prüfsignalen unterschiedlich sind. In dem nachfolgend beschriebenen Beispiel umfasst die mindestens eine höhere Harmonische zwei höhere Harmonische, nämlich die vierte und fünfte Harmonische. In anderen Beispielen können weitere oder andere Harmonische zur Unterscheidung der verschiedenen Prüfsignalen verwendet werden. Prinzipiell genügt jedoch bereits eine höhere Harmonische, um die verschiedenen Prüfsignale zu unterscheiden. Vorteil der Verwendung mehrerer höherer Harmonischer ist, dass dadurch die Unterscheidung der Prüfsignale verbessert wird, beispielsweise wenn die Prüfsignale gestört oder verrauscht werden. Die Prüfsignale erhalten durch die unterschiedlichen Amplituden und/oder Phasen in der mindestens einen höheren Harmonischen eine Kodierung. Diese Kodierung kann beispielsweise eine Phaseninformation in einem mehrphasigen elektrischen System darstellen, welche anzeigt, welcher Phase der elektrischen Anlage 100 das Prüfsignal zugeordnet ist.

Um die Phaseninformation in das Sägezahn-ähnliche Signal zu kodieren, werden die Amplitude und Phase von beispielsweise zwei höheren Harmonischen leicht geändert. Zum Beispiel werden die vierte und fünfte Harmonische verändert, um diese Phaseninformation zu kodieren, während die Grundschwingung und die zweite und dritte Harmonische unverändert bleiben. Insgesamt werden nur fünf Harmonische verwendet, um die Bandbreite des Prüfsignals zu begrenzen. Die folgende Gleichung zeigt die Definition des modifizierten Prüfsignals *y(t)* mit fünf Harmonischen (k=5).

$$y(t) = \sum_{n=1}^{k} a_n \frac{1}{n^2}\sin(2\pi n f_g t + \varphi_n)$$

Die verwendeten Amplitudenvariationen $a_n$ und Phasenvariationen $\varphi_n$ können durch Einführung eines Amplitudenmodifikators *A[n]* und eines Phasenmodifikators *P[n]* für die *n-te* Harmonische dargestellt werden. Beide können beispielsweise drei bestimmte Werte haben, die beispielsweise mit -1, 0 und +1 bezeichnet werden. Die verwendeten Zuordnungen zu $a_n$ und $\varphi_n$ in obiger Gleichung sind in der nachfolgenden Tabelle 1 dargestellt.

Tabelle 1: Amplituden- und Phasenvariation

| Parameter | Koeffizienten | | | | |
|---|---|---|---|---|---|
| | n = 1 | n = 2 | n = 3 | n = 4 | n = 5 |
| *an* | 1 | 1 | 1 | *A[4] = 1: 1,35*<br>*A[4]* = 0: *1,00*<br>*A[4] = -1: 0,65* | *A[5] = 1: 1,50*<br>*A[5] = 0: 1,00*<br>*A[5] = -1: 0,50* |
| $\varphi_n$ | 0 | 0 | 0 | *P[4]* = 1: *0,5 rad*<br>*P[4]* = 0: *0,0 rad*<br>*P[4]* = -1: *-0,5 rad* | *P[5]* = 1: *0,5 rad*<br>*P[5]* = 0: *0,0 rad*<br>*P[5]* = -1: *-0,5 rad* |

Es ist klar, dass die Amplituden- und und Phasenvariationen auch auf andere Art und Weise dargestellt werden können, beispielsweise direkt durch die entsprechenden Amplitudenfaktoren und Phasenwinkel. Ebenso ist klar, dass eine andere Anzahl als drei Werte für die Variation verwendet werden können, beispielsweise zwei oder mehr als drei. Die Phasenwinkel sind in der Tabelle 1 in Radiant angegeben. 0,5 rad entsprechen etwa 28,6°. In anderen Beispielen können

andere Phasenwinkel zur Variation verwendet werden, beispielsweise +/-20° oder +/-40°.

Durch die verhältnismäßig kleinen Amplituden der vierten und/oder fünften Harmonischen ändert sich die asymmetrische Signalform nur unwesentlich. Niedrigere Harmonische, wie beispielsweise die zweite und dritte Harmonische, eignen sich weniger für eine Kodierung der Phaseninformation, da sie die Asymmetrie des Signals im Zeitbereich wesentlich beeinflussen und daher eine Erkennung, insbesondere der Polarität, erschweren könnten. Noch höhere Harmonische, insbesondere siebte oder höhere Harmonische, sind ebenfalls weniger geeignet, da Strom- und Spannungswandler üblicherweise hohe Frequenzen wesentlich stärker dämpfen und somit die Übertragung und Erkennung beeinträchtigen könnten.

Dieses Schema der Amplituden- und Phasenvariation mit drei festgelegten Werten für die beiden Amplituden- und die beiden Phasenmodifikatoren ermöglicht die Kodierung von $3^{2+2} = 81$ verschiedenen Codewörtern. Es ist klar, dass alternativ auch nur eine Amplitudenvariation oder nur eine Phasenvariation verwendet werden kann. Bei beispielsweise nur einer Phasenvariation haben die Amplitudenmodifikatoren *A[n]* den Wert 0, also hat die Amplitudenvariation $a_n$ den Wert 1.

Um die Robustheit der Kodierung zu erhöhen, werden beispielsweise nur fünf der 81 möglichen Codewörter verwendet, die nachfolgend mit CWS, CW1, CW2, CW3 und CW4 bezeichnet werden. CWS steht für ein unverändertes Sägezahn-ähnliches Prüfsignal. CW1 - CW4 können verwendet werden, um vier verschiedene Phasen oder Stromkreise einer elektrischen Anlage zu identifizieren. Das Codewort CW4 für die vierte Phase wird in der Regel in dreiphasigen Anlagen und Netzen nicht benötigt, aber hier aus Gründen der Symmetrie zumindest mit erörtert.

Die nachfolgende Tabelle 2 zeigt eine beispielhafte Zuordnung der Codewörter zu den Amplituden- und Phasenmodifikatoren A und P.

| | | Amplituden- and Phasenmodifikatoren | | | |
|---|---|---|---|---|---|
| | | *A[4]* | *P[4]* | *A[5]* | *P[5]* |
| Codewort | CWS | 0 | 0 | 0 | 0 |
| | CW1 | +1 | -1 | -1 | +1 |
| | CW2 | -1 | -1 | +1 | +1 |
| | CW3 | +1 | +1 | -1 | -1 |
| | CW4 | -1 | +1 | +1 | -1 |

Tabelle 2: Abbildung von Codeworten auf Amplituden- und Phasen-Modifikatoren

Alle verschiedenen Codewörter unterscheiden sich in mindestens zwei Modifikatoren voneinander. Die Summe der Differenzen der Amplituden- und Phasenmodifikatoren A und P für jede Kombination von verwendeten Codewörtern kann berechnet werden, um den Hamming-Abstand der Codewörter zu erhalten. Die folgende Tabelle 3 zeigt die resultierenden Hamming-Abstände.

| Hamming-Abstand | | von Codewort | | | | |
|---|---|---|---|---|---|---|
| | | CWS | CW1 | CW2 | CW3 | CW4 |
| zu Codewort | CWS | - | 4 | 4 | 4 | 4 |
| | CW1 | 4 | - | 4 | 4 | 4 |
| | CW2 | 4 | 4 | - | 4 | 4 |
| | CW3 | 4 | 4 | 4 | - | 4 |
| | CW4 | 4 | 4 | 4 | 4 | - |

Tabelle 3: Hamming-Abstände zwischen Codeworten

Zwischen allen verwendeten Codewörtern besteht ein Mindestabstand von 4, der es ermöglicht, einen einzelnen Fehler, wie einen falsch erkannten Amplituden- oder Phasenwert, zu erkennen und zu korrigieren. Außerdem können zwei falsch erkannte Modifikatoren als Fehler erkannt, allerdings nicht korrigiert werden. Im Falle eines einzelnen falschen Symbols wird das nächste gültige Codewort mit einem Hamming-Abstand von 1 verwendet. Ist der Abstand größer, wird es als fehlerhaftes Codewort betrachtet.

In diesem Zusammenhang würde dies bedeuten, dass die Phaseninformation eines stark verzerrten Signals nicht korrekt dekodiert werden kann, aber es kann immer noch erkannt werden, dass es sich um ein gültiges Polaritätsprüfungssignal handelt.

Für das Verfahren kann ein Signal mit einer Grundfrequenz von 52,6 Hz verwendet werden. Die Begrenzung des Signals auf die fünfte Harmonische ergibt 263 Hz als höchste Frequenz. Da die verwendete Kodierung statisch ist, gibt es keine höheren Frequenzen aufgrund von Modulation. Herkömmliche Strom- und Spannungswandler können diese eher niedrigen Frequenzen ohne größere Dämpfung oder Phasenverschiebungen übertragen.

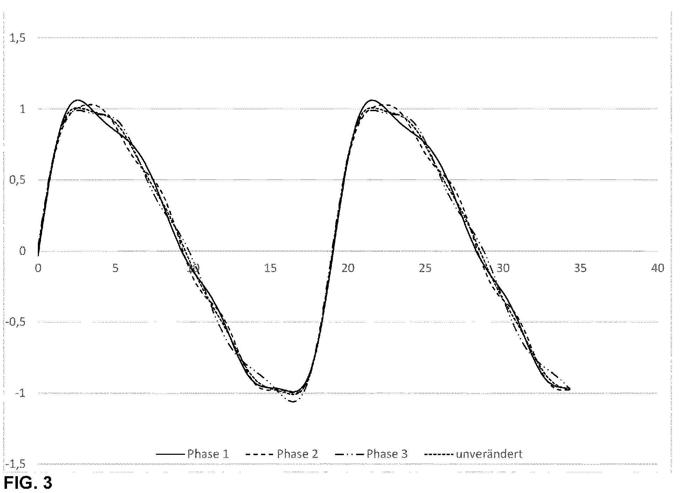

Fig. 3 zeigt Signalformen der Prüfsignale für die Phasen 1, 2 und 3 basierend auf den Kodierungen CW1, CW2 und CW3 sowie das auf der Kodierung CWS basierende unveränderte Prüfsignal. Wie aus der Fig. 3 ersichtlich ist, ist die asymmetrische Signalform im Zeitbereich bei allen Prüfsignalen deutlich zu erkennen, das heißt, die Signale haben alle im Wesentlichen eine verhältnismäßig steile steigende Flanke und eine verglichen mit der steigenden Flanke verhältnismäßig flache fallende Flanke.

Im Schritt 204 werden die erzeugten Prüfsignale 160 bis 162 für die Phasen 1, 2 und 3 an der ersten Stelle 141 über die ersten Anschlüsse 142 bis 144 in die Außenleiter 120 bis 122 eingespeist. Die Prüfsignale 160 bis 162 können gleichzeitig eingespeist werden. Die so eingespeisten Prüfsignale laufen durch die elektrische Komponente 110, die beispielsweise ein oder mehrere Transformatoren oder Kapazitäten oder sonstige elektrotechnische Einrichtungen, wie zum Beispiel Leistungsschalter umfasst. An der zweiten Seite 114 gibt die elektrische Komponente 110 aufgrund der eingespeisten Prüfsignale Ausgangssignale auf den drei Außenleitern 130 bis 132 aus. Bei einer richtig angeschlossenen elektrischen Komponente 110 wird beispielsweise erwartet, dass das Prüfsignal, welches auf dem Außenleiter 120 eingespeist wurde, im Wesentlichen auf dem Außenleiter 130 ausgegeben wird, beispielsweise mit veränderter Spannung im Falle eines Transformators. Die Signalform wäre jedoch erwartungsgemäß im Wesentlichen unverändert. Ebenso wird bei richtig angeschlossener elektrischer Komponente 110 beispielsweise erwartet, dass das in den Außenleiter 121 eingespeiste Signal im Wesentlichen auf den Außenleiter 131 ausgegeben wird und das in den Außenleiter 122 eingespeiste Signal im Wesentlichen auf dem Außenleiter 132 ausgegeben wird.

Bei einer fehlerhaften Verdrahtung, bei der die Außenleiter 121 und 122 vertauscht angeschlossen wurden, wird hingegen das auf den Außenleiter 121 eingespeiste Signal auf den Außenleiter 132 ausgegeben und das auf den Außenleiter 122 eingespeiste Signal auf den Außenleiter 131.

Im Schritt 206 werden mehrere Messsignale an der zweiten Stelle 145 erfasst. Die mehreren Messsignale können gleichzeitig oder nacheinander erfasst werden. In der Erfassungsvorrichtung 156 können die erfassten Messsignale optional vorbehandelt werden, beispielsweise durch Filterung. Beispielsweise können die Messsignale mit analogen und/oder digitalen Filtern vorverarbeitet werden, um zum Beispiel Störungen durch resistive, induktive oder kapazitive Kopplungen zu unterdrücken, beispielsweise einen resistiven Spannungsabfall durch Stromfluss über einen gemeinsamen Rückleiter. Derartige Störungen können beispielsweise von benachbarten im Betrieb befindlichen Systemen auf die Außenleiter 120 bis 122 und 130 bis 132 wirken. Ferner können beispielsweise Kerbfilter für Netzfrequenzen, zum Beispiel mit 50 Hz, 60 Hz oder 16,7 Hz oder einer Kombination daraus, verwendet werden, um Störungen von

benachbarten Systemen herauszufiltern. Weitere Kerbfilter können für höhere Harmonische der Netzfrequenz zur Filterung der Messsignale eingesetzt werden. Alternativ oder zusätzlich können Tiefpassfilter zur Entfernung höherer Harmonischer und anderer Störungen auf die Messsignale angewendet werden. Eine Grenzfrequenz kann dabei höher als die Frequenz der höchsten verwendeten Harmonischen im Prüfsignale sein. Schließlich kann ein Hochpassfilter zur Entfernung niederfrequenter Störungen auf die Messsignale angewendet werden, wobei die Grenzfrequenz niedriger als die Grundfrequenz der Prüfsignale sein kann. Durch die Vorverarbeitung der Messsignale kann die Zuverlässigkeit der Überprüfung der Verdrahtung und die Störempfindlichkeit gegenüber benachbarten im Betrieb befindlichen Systemen erhöht werden.

Im Schritt 208 erfolgt eine Bestimmung einer Zuordnung zwischen Prüfsignalen und Messsignalen. Anders ausgedrückt erfolgt im Schritt 208 eine Identifikation der Prüfsignale in den Messsignalen. Die Identifikation der einzelnen Prüfsignale in den Messsignalen kann ein Bestimmen von Amplituden und Phasen von Spektralkomponenten für Frequenzen der vorgegebenen Harmonischen, insbesondere der für die Kodierung verwendeten höheren Harmonischen, in den Messsignalen umfassen. Die Amplituden und Phasen dieser Spektralkomponenten können mit Amplitudenschwellenwerten bzw. Phasenschwellenwerten verglichen werden. Die Amplitudenschwellenwerte können in Abhängigkeit von einer Amplitude einer Grundschwingung der im Zeitbereich asymmetrischen Signalform eingestellt werden.

Wurde die Grundfrequenz $f_g$ wie zuvor beschrieben geeignet gewählt, beispielsweise zu 52,6 Hz, so ergeben sich keine Überschneidungen mit der Netzfrequenz oder höheren Harmonischen der Netzfrequenz.

Wie zuvor beschrieben, sind die Informationen zur Identifizierung einer Phase robust in Sägezahn-ähnlichen Prüfsignalen kodiert. Dies ermöglicht die Überprüfung der korrekten Polarität und Phasenzuordnung ohne die Notwendigkeit einer gemeinsamen Referenz und ohne Abhängigkeit von der Signalamplitude.

Das Dekodieren modifizierter Sägezahn-ähnlichen Prüfsignale aus den erfassten Messsignalen kann beispielsweise in folgenden Schritten durchgeführt werden.

In einem ersten Schritt kann das empfangene Messsignal mit einem Tiefpassfilter gefiltert werden, um seine Bandbreite auf beispielsweise 263 Hz zu begrenzen, also auf die Frequenz, welche als höchste Frequenz bei der Erzeugung der Prüfsignale verwendet wurde. In dem oben genannten Beispiel wurde eine Grundfrequenz von 52,6 Hz verwendet, sodass die höchste Frequenz der fünften Harmonischen 263 Hz beträgt. Zum Beispiel kann hierfür ein Butterworth-Tiefpassfilter achter Ordnung als Vorfilter verwendet werden.

In einem zweiten Schritt wird das Messsignal auf die Frequenzkomponenten der in diesem Beispiel fünf verwendeten Harmonischen hin untersucht. Die Periodendauern von jedem dieser interessierenden Signale ist bekannt (beispielsweise 52,6 Hz sowie ganzzahlige Vielfache davon) und daher kann beispielsweise ein Goertzel-Algorithmus verwendet werden, um eine diskrete Fouriertransformation (DFT) auszuführen. Der Goertzel-Algorithmus liefert die Amplitude und Phase und wird auf alle interessierenden Frequenzen, beispielsweise die fünf Frequenzen der fünf verwendeten Harmonischen angewendet. Es können längere Integrationsintervalle von beispielsweise 20 Perioden verwendet werden, um zusätzlich Rauschen und Störungen zu unterdrücken, indem ein Mittelungseffekt ausgenutzt wird.

Schließlich wird die Phaseninformation dekodiert. Die Amplitude der vierten und fünften Harmonischen wird anhand der durchschnittlichen Amplitude der ersten drei Harmonischen normalisiert. Dann prüft beispielsweise ein Diskriminator die Harmonischen auf Amplituden- und Phasenabweichungen von den in Tabelle 1 angegebenen Werten und weist den erkannten Amplituden- und Phasenmodifikatoren einen Wert von +1 (wenn > 150 % des Nennwerts), -1 (wenn < 50 % des Nennwerts) oder 0 (wenn dazwischen) zu und ordnet sie einem der 81 möglichen Codewörter zu. Dann kann der Hamming-Abstand zwischen dem empfangenen Codewort und allen fünf gültigen Codewörtern berechnet werden. Wird ein Codewort mit einem Abstand von 0 oder 1 gefunden, wird es vom Detektor als korrektes Codewort akzeptiert. Anhand der so ermittelten Phaseninformationen kann ermittelt werden, welches Prüfsignal in welchem Messsignal enthalten ist und somit an welchem Außenleiter ein eingegebenes Prüfsignal ausgegeben wird.

Wird eine Hamming-Distanz von zwei oder mehr gemeldet, kann es zwar als Polaritätsprüfungssignal verwendet werden, aber es kann keine Phaseninformation sicher daraus abgeleitet werden. Aber es wird zumindest erkannt, dass das Prüfsignal erheblich gestört ist, was an eine Bedienperson ausgegeben werden kann.

Anhand der im Schritt 208 bestimmten Zuordnung zwischen Prüfsignalen und Messsignalen kann auf einfache Art und Weise festgestellt werden, ob die erwarteten Prüfsignale an den entsprechenden Außenleitern 130 bis 132 erfasst wurden. Bei nicht erwartungsgemäßen Zuordnungen kann eine fehlerhafte Verdrahtung festgestellt werden.

Im Schritt 210 werden Polaritäten der Messsignale, welche an der zweiten Stelle 145 erfasst wurden, bestimmt. Die Erkennung der Polarität basiert auf der im Zeitbereich asymmetrischen Signalform.

Zum Beispiel kann eine Erkennung der Polarität folgendermaßen durchgeführt werden. Die Amplituden der Harmonischen werden mit der erkannten Grundschwingung verglichen. Wenn die zweite und dritte Harmonische innerhalb von +/- 50 % der erwarteten relativen Amplitude liegen und die Phase +/- ~30° (0,5 rad) innerhalb der erwarteten Werte liegt, wird dies als ein gültiges Sägezahn-ähnliches Signal, also ein Sägezahn-ähnliches Signal mit korrekter Polarität, gewertet. Bei korrekter Polarität haben alle Harmonischen im Wesentlichen die gleiche Phase wie die Grundwelle, abgesehen von der eingestellten Phasenvariation. Im Falle eines invertierten Signals wird jede zweite Harmonische

im Frequenzbereich invertiert, was zu einer Phasenverschiebung von 180° führt. Dies ist erheblich größer als die Phasenvariation. Daher wird ein Phasenwert von 0° und 180° (+/- 30°) für die zweite Harmonische, aber nur 0° (+/- 30°) für die dritte Harmonische als ein Sägezahn-ähnliches Signal mit korrekter Polarität angesehen. Bei einer Polarität von ~ 0° wird die Polarität als korrekt, bei ~ 180° als falsch (invertiert) angesehen.

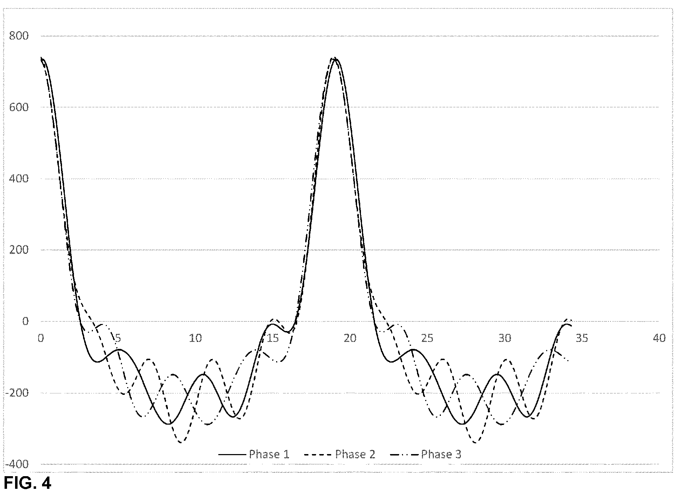

In einem weiteren Beispiel kann die Polarität wie folgt beurteilt werden. Für die Messsignale, welche wie zuvor beschrieben vorbehandelt sein können, werden jeweilige Ableitungen im Zeitbereich gebildet. Eine jeweilige Ableitung kann zum Beispiel durch eine zeitdiskrete numerische Ableitung unter Verwendung von Differenzen zeitlich aufeinander erfasster Signalpegel oder implizit durch entsprechend angepasste Filterstrukturen ermittelt werden, zum Beispiel durch die Verwendung eines analogen Operationsverstärkers als Differenzierschaltung oder in digitalen Filterstrukturen. Fig. 4 zeigt resultierende Ableitungen $dM_p(t)/dt$ für die Messsignale $M_p(t)$ für die Phasen p = 1, 2 und 3, die als Antwort auf die Prüfsignale für die Phasen 1, 2 und 3 basierend auf den Kodierungen CW1, CW2 und CW3 erhalten werden (bei korrekter Verdrahtung und Polarität). Für jede der Ableitungen kann ein sprechendes Hilfssignal $Q_p(t)$ gebildet werden, zum Beispiel gemäß der folgenden Vorschrift:

$$Q_p(t) = \begin{cases} 1, \text{wenn} \dfrac{M_p(t)}{dt} > \delta \\ -1, \text{wenn} \dfrac{M_p(t)}{dt} < -\delta \\ 0, \text{sonst} \end{cases}$$

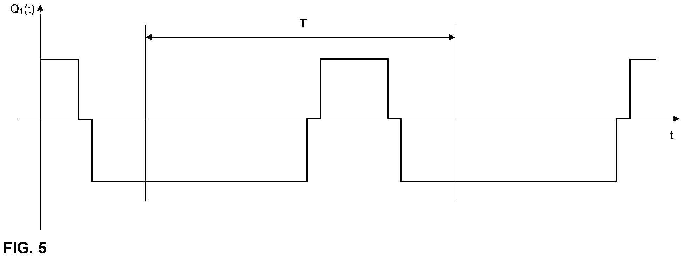

Dabei ist δ Schwellenwert, welcher verwendet wird, um Rauschen und andere unerwünschte Störungen zu unterdrücken. Fig. 5 zeigt beispielhaft das Hilfssignal $Q_1(t)$ für das Prüfsignal für Phase 1. Basierend auf dem Hilfssignal $Q_p(t)$ wird ein entsprechender Mittelwert $\overline{Q_p(t)}$ über eine bestimmte Zeit berechnet. Dieser Mittelwert kann beispielsweise über eine diskrete Zeit, beispielsweise eine Periodendauer T der Grundschwingung der Prüfsignale oder kontinuierlich mittels eines Tiefpassfilters berechnet werden. Überschreitet dieser Mittelwert eine definierte positive Schwelle, so wird eine positive Polarität angezeigt (kurze steigende Flanke und lange fallende Flanke). Unterschreitet der Mittelwert eine definierte negative Schwelle, wird eine negative Polarität angezeigt (lange steigende Flanke und kurze fallende Flanke). Ein Polaritätswechsel, welcher beispielsweise aufgrund einer fehlerhaften Verdrahtung auftreten kann, kann somit auf einfache Art und Weise für jede Phase bestimmt werden.

Im Schritt 212 können die so bestimmten Phasenzuordnungen und Polaritäten beispielsweise auf einer Anzeigevorrichtung für einen Benutzer ausgegeben werden.

Beispielsweise kann auf Leitung 170 ein erstes Prüfsignal für Phase 1 ausgegeben werden, auf Leitung 171 ein zweites Prüfsignal für Phase 2 und auf Leitung 172 ein drittes Prüfsignal für Phase 3. Bei richtiger Verdrahtung der elektrischen Anlage 100 zeigt die Prüfvorrichtung 150 für die Leitung 180 an, dass das erste Prüfsignal erkannt wurde, für die Leitung 181, dass das zweite Prüfsignal erkannt wurde, und für die Leitung 182, dass das dritte Prüfsignal erkannt wurde. Ferner kann die Prüfvorrichtung 150 anzeigen, dass die Prüfsignale jeweils mit positiver Polarität ausgegeben und erkannt wurden. Verdrahtungsfehler, beispielsweise vertauschte Außenleiter oder eine Fehlverdrahtung, die zu einer Invertierung der Polarität führt, beispielsweise an einem Transformator, können anhand der Ausgaben von einer Bedienperson identifiziert werden.

Alternativ oder zusätzlich können im Schritt 214 die erkannten Phasenzuordnungen mit Soll-Zuordnungen und/oder die erkannten Polaritäten mit Soll-Polaritäten verglichen werden und automatisch eine Warnung ausgegeben werden, wenn eine Abweichung zwischen dem erkannten Zustand und dem Soll-Zustand festgestellt wurde.

Die elektrische Anlage 100 kann noch weitere Anschlüsse aufweisen, beispielsweise weitere dreiphasige Anschlüsse, deren Verdrahtung auf gleiche Art und Weise wie zuvor beschrieben überprüft werden kann. Diese Anschlüsse können beispielsweise Hilfsstromkreise oder Steuerstromkreise betreffen, die je nach Art des Stromkreises auch mit dem obigen Verfahren geprüft werden können.

Werden mehrere Stromkreise bzw. Phasen geprüft, können diese einen gemeinsamen Neutralleiter verwenden (N für L1, L2 und L3) oder komplett getrennte Stromkreise (L1+N1, L2+N2, L3+N3) sein. Auch hier sind verschiedene Verdrahtungsfehler denkbar und können mit dem Verfahren erkannt werden. Bei Verdrahtungsfehlern können mehrfache Erdverbindungen vorkommen. Mittels beispielsweise einer Stromzange kann der Strom über die Erdverbindung als eines der mehreren Messsignale gemessen werden. Durch das beschriebene Verfahren kann über die Zuordnungen erkannt werden, welche Prüfsignale in der Erdverbindung erkannt werden konnten und somit können gewünschte und unge-wünschte Erdverbindungen identifiziert werden.

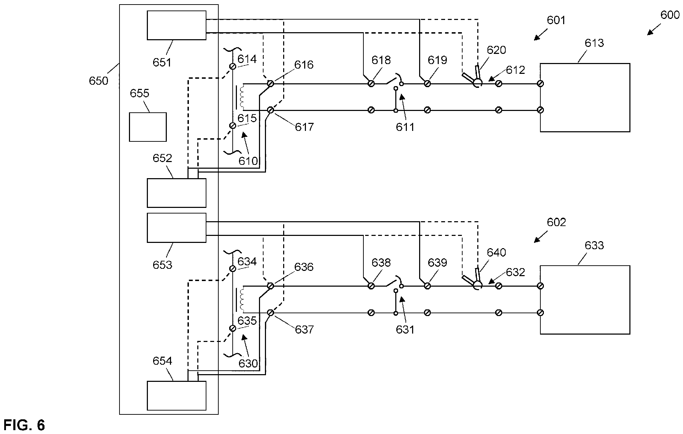

Fig. 6 zeigt schematisch einen Ausschnitt einer weiteren elektrischen Anlage 600, an welche eine Prüfvor-richtung 650 zum Prüfen einer Verdrahtung der elektrischen Anlage 600 angeschlossen ist. Die elektrische Anlage 600 umfasst mehrere Stromkreise, welche einer oder mehreren Phasen zugeordnet sein können. In dem in Fig. 6 gezeigten Beispiel umfasst die elektrische Anlage 600 zwei Stromkreise 601 und 602, welche im Wesentlichen voneinander getrennt

sind. Die Stromkreise 601 und 602 können jedoch auch einer Phase eines mehrphasigen Systems, also derselben Phase des mehrphasigen Systems, oder mehreren unterschiedlichen Phasen eines mehrphasigen Systems zugeordnet sein oder über ihre Neutralleiter miteinander verbunden sein. In anderen Beispielen kann die elektrische Anlage 600 mehr als zwei Stromkreise umfassen. Die elektrische Anlage 600 kann beispielsweise eine Hochspannungsanlage oder einen Teil davon umfassen. Jeder der Stromkreise 601 und 602 kann eine oder mehrere elektrische Komponente umfassen, beispielsweise Strom- oder Spannungswandler 610, 630, Sekundärverkabelung 612, 632, Anpasswandler, Prüfstecker 614-619, 634-639, Prüfschalter 611, 631, Zähler und/oder Schutzgeräte, wie zum Beispiel Relais 613, 633.

Nach einer Installation oder Reparatur an der elektrischen Anlage 600 kann es erforderlich sein, die Verdrahtung zu überprüfen. Um die Verdrahtung zu überprüfen, kann die in Fig. 6 gezeigte Prüfvorrichtung 650 elektrisch mit beiden Stromkreisen 601 und 602 gekoppelt werden.

Die Prüfvorrichtung 650 umfasst mehrere Prüfsignalerzeugungsvorrichtungen, welche mehrere Prüfsignale erzeugen. In Fig. 6 sind zwei Prüfsignalerzeugungsvorrichtungen 652 und 654 zur Erzeugung von zwei Prüfsignalen gezeigt. Die mehreren Prüfsignale können auch von einer gemeinsamen Prüfsignalerzeugungsvorrichtung erzeugt werden. Jeder der Prüfsignalerzeugungsvorrichtungen 652 und 654 ist eine entsprechende (nicht gezeigte) Einspeisevorrichtung zugeordnet, mit welcher die Prüfsignale über entsprechende Leitungen an entsprechenden Einspeisestellen in die elektrischen Anlage 600 eingespeist werden. Die Einspeisevorrichtungen können beispielsweise die Prüfsignale von den Prüfsignalerzeugungsvorrichtungen 652, 654 an einen an der entsprechenden Einspeisestelle erforderlichen Nominalbereich anpassen. **In** dem in Fig. 6 gezeigten Beispiel kann das Prüfsignal von der Prüfsignalerzeugungsvorrichtung 652 beispielsweise an Prüfsteckern 616, 617 an einer Sekundärseite eines Wandlers 610, beispielsweise eines Stromwandlers oder Spannungswandlers, eingespeist werden. Alternativ kann das Prüfsignal von der Prüfsignalerzeugungsvorrichtung 652 auch an Prüfsteckern 614, 615 an einer Primärseite des Wandlers 610 eingespeist werden, wie es durch die gestrichelten Leitungen gezeigt ist. Durch Einspeisen an der Primärseite kann zusätzlich die Polarität und Verkabelung des Wandlers 610 überprüft werden. Bei einer Einspeisung an der Primärseite können bei Stromwandlern entsprechend höhere Ströme und bei Spannungswandlern entsprechend höhere Spannungen erforderlich sein. Ebenso kann das Prüfsignal von der Prüfsignalerzeugungsvorrichtung 654 beispielsweise an Prüfsteckern 636, 637 an einer Sekundärseite eines Wandlers 630 eingespeist werden. Alternativ kann das Prüfsignal von der Prüfsignalerzeugungsvorrichtung 654 auch an Prüfsteckern 634, 635 an einer Primärseite des Wandlers 630 eingespeist werden, wie es durch die gestrichelten Leitungen gezeigt ist, um zusätzlich die Polarität und Verkabelung des Wandlers 630 zu überprüfen.

Die Prüfvorrichtung 650 umfasst weiterhin mehrere Erfassungsvorrichtungen zum Erfassen von Messsignalen. **In** dem Beispiel der Fig. 6 umfasst die Prüfvorrichtung 650 zwei Erfassungsvorrichtungen 651 und 653, welche über entsprechende Leitungen mit dem ersten bzw. zweiten Stromkreis 601, 602 gekoppelt sind. Beispielsweise kann die Erfassungsvorrichtung 651 mit Prüfsteckern 618, 619 an dem Prüfschalter 611 gekoppelt werden, um eine Spannung an dem Prüfschalter 611 als Messsignal zu erfassen. Wie durch die gestrichelten Leitungen dargestellt, kann die Erfassungsvorrichtung 651 alternativ mit Prüfsteckern 616, 617 zur Erfassung einer Spannung an der Sekundärseite des Wandlers 610 oder mit einer Stromzange 620 zur Erfassung eines Stroms durch die Verkabelung 612 gekoppelt werden. Auf gleiche Art und Weise kann die Erfassungsvorrichtung 653 mit dem zweiten Stromkreis 602 gekoppelt werden. Wie in Fig. 6 gezeigt, kann die Erfassungsvorrichtung 653 mit den Prüfsteckern 638, 639 an dem Prüfschalter 631 gekoppelt werden, um eine Spannung an dem Prüfschalter 631 als Messsignal zu erfassen. Alternativ kann die Erfassungsvorrichtung 653 mit Prüfsteckern 636, 637 zur Erfassung einer Spannung an der Sekundärseite des Wandlers 630 oder mit einer Stromzange 640 zu Erfassung eines Stroms durch die Verkabelung 632 gekoppelt werden.

Die Prüfvorrichtung 650 umfasst weiterhin eine Verarbeitungsvorrichtung 655, welche in der Fig. 6 als eigene Komponente gezeigt ist. In anderen Beispielen kann die Verarbeitungsvorrichtung 655 auch integriert mit einer der Prüfsignalerzeugungsvorrichtungen 652, 654 oder der Erfassungsvorrichtungen 651, 653 ausgebildet sein. Die Verarbeitungsvorrichtung 655 umfasst beispielsweise eine elektronische Steuerung, beispielsweise eine Mikroprozessorsteuerung, welche beispielsweise ein Computerprogramm ausführen kann. Die Verarbeitungsvorrichtung 655 kann mit den Prüfsignalerzeugungsvorrichtungen 652, 654 und den Erfassungsvorrichtungen 651, 653 gekoppelt sein, um diese in einer koordinierten Art und Weise anzusteuern, wie es nachfolgend im Detail beschrieben werden wird. In anderen Beispielen ist die Verarbeitungsvorrichtung nicht mit den Prüfsignalerzeugungsvorrichtungen 652, 654 verbunden und die Prüfsignalerzeugungsvorrichtungen 652, 654 erzeugen die Prüfsignale unabhängig von einer Steuerung durch die Verarbeitungsvorrichtung 655. Die Prüfsignalerzeugungsvorrichtungen 652, 654, die Erfassungsvorrichtungen 651, 653 und die Verarbeitungsvorrichtung 655 müssen nicht in ein und demselben Gehäuse oder in einer Einheit ausgebildet sein, sondern können räumlich unabhängige Einheiten mit eigenen Gehäusen umfassen. Beispielsweise können die Prüfsignalerzeugungsvorrichtungen 652, 654 jeweils eine Einheit bilden, welche unabhängig betrieben und aufgestellt werden können. Eine weitere Einheit kann die Erfassungsvorrichtungen 651, 653 und die Verarbeitungsvorrichtung 655 umfassen und mit den Prüfsignalerzeugungsvorrichtungen 652, 654 gekoppelt sein. Dadurch kann auch bei großen elektrischen Anlagen, bei denen die Einspeisestellen räumlich weit von den Messstellen entfernt sind, die Prüfvorrichtung 650 verwendet werden, ohne dass entsprechend lange Leitungen zwischen den Prüfsignalerzeugungsvorrichtungen 652, 654 und den entsprechenden Einspeisestellen erforderlich sind.

Die Arbeitsweise der Prüfvorrichtung 650 entspricht im Wesentlichen der zuvor unter Bezugnahme auf die Figuren 1 bis 5 im Detail beschriebenen Arbeitsweise der Prüfvorrichtung 150. Wie zuvor beschrieben, kann das in Fig. 2 gezeigte Verfahren 200 von der Prüfvorrichtung 650 ausgeführt werden, um die Verdrahtung der elektrischen Anlage 600 zu prüfen.

Im Schritt 202 werden in diesem Fall zwei Prüfsignale erzeugt. Für jeden Stromkreis 601, 602 wird ein eigenes Prüfsignal $P_p(t)$ erzeugt, welches eine im Zeitbereich asymmetrische Signalform und eine Kombination von vorgegebenen Harmonischen mit mindestens einer höheren Harmonischen aufweist. Der Index p bezeichnet den Stromkreis, für den das Prüfsignal $P_p(t)$ vorgesehen ist, zum Beispiel $p=1$ für den Stromkreis 601 und p=2 für den Stromkreis 602. Die zwei Prüfsignale unterscheiden sich dadurch voneinander, dass die Phasenlagen (im Folgenden auch kurz Phase) bei der mindestens einen höheren Harmonischen unterschiedlich sind. Beispielsweise können die Prüfsignale auf einem gemeinsamen Signal $P(t)$ basieren, welches eine im Zeitbereich asymmetrische Signalform hat. Die Signalform des gemeinsamen Signals $P(t)$ kann einer Sägezahnsignalform angenähert sein. Dazu können beispielsweise Sinussignale mit verschiedener Amplitude und Frequenz verwendet werden, welche mittels Fourier-Synthese die Sägezahnsignalform annähernd nachbilden. Beispielsweise kann als gemeinsames Signal $P(t)$ ein Signal gemäß folgender Gleichung verwendet werden:

$$P(t) = A \sum_{n=1}^{k} \frac{1}{n^2} \sin\left(2\pi n f_g t\right)$$

A stellt hier die Amplitude des gesamten Signals dar, k die Anzahl der verwendeten Harmonischen und fg die Grundfrequenz des Signals. Der Term $\frac{1}{n^2}$ gewichtet die einzelnen Sinusfunktionen, um in Summe die Sägezahnsignalform anzunähern.

Beispielsweise kann ein Signal mit $A = 1$, $k = 3$ und $f_g = 52{,}6$ Hz gebildet werden. In anderen Beispielen kann A auch so gewählt werden, dass ein Effektivwert (RMS) des Signals annähernd 1 beträgt.

Jedes der zwei Prüfsignale $P_p(t)$ umfasst weiterhin mindestens eine höhere Harmonische, wobei die Phasen dieser mindestens einen höheren Harmonischen bei den verschiedenen Prüfsignalen unterschiedlich sind. In dem nachfolgend beschriebenen Beispiel umfasst die mindestens eine höhere Harmonische nur eine höhere Harmonische, nämlich die vierte Harmonische. Die Prüfsignale erhalten somit eine Kodierung. Diese Kodierung kann beispielsweise eine Stromkreisinformation in dem elektrischen System 600 mit den zwei Stromkreisen 601 und 602 darstellen, welche anzeigt, welchem Stromkreis das Prüfsignal zugeordnet ist.

Um die Stromkreisinformation in das Sägezahn-ähnliche Signal zu kodieren, wird die Phase von der vierten Harmonischen leicht geändert, während die Grundschwingung und die zweite und dritte Harmonische unverändert bleiben. Insgesamt werden nur vier Harmonische verwendet, um die Bandbreite des Prüfsignals zu begrenzen. Die folgende Gleichung zeigt die Definition des modifizierten Prüfsignals $y(t)$ mit vier Harmonischen (k=4).

$$y(t) = \sum_{n=1}^{k} \frac{1}{n^2} \sin\left(2\pi n f_g t + \varphi_n\right)$$

Die verwendeten Phasenvariationen können durch Einführung eines Phasenmodifikators P[4] für die vierte Harmonische dargestellt werden. Dieser kann beispielsweise zwei bestimmte Werte haben, die beispielsweise mit -1 und +1 bezeichnet werden. Die verwendete Zuordnung zu $\varphi_n$ in obiger Gleichung ist beispielsweise:

$$\varphi_1 = 0,$$

$$\varphi_2 = 0,$$

$$\varphi_3 = 0,$$

$\varphi_4 = 0{,}5$ rad für P[4] = 1 und $\varphi_4 = -0{,}5$ rad für P[4] = -1.

Ähnlich wie in Verbindung mit dem Beispiel der Figur 1 beschrieben, stellt hier jeder Wert des Phasenmodifikators P[4] somit ein Codewort dar, z.B. P[4] = 1 ist Codewort CW1 und P[4] = -1 ist Codewort CW2.

Im Schritt 204 werden die erzeugten Prüfsignale in die Stromkreise 601, 602 wie zuvor beschrieben eingespeist.

Die Prüfsignale können gleichzeitig eingespeist werden. Die so eingespeisten Prüfsignale laufen durch die elektrischen Komponenten, die beispielsweise ein oder mehrere Transformatoren oder Kapazitäten oder sonstige elektrotechnische Einrichtungen, wie zum Beispiel Leistungsschalter oder Prüfschalter umfassen. An den oben beschriebenen Messstellen werden aufgrund der eingespeisten Prüfsignale Ausgangssignale erzeugt. Bei richtig angeschlossenen elektrischen Komponenten wird beispielsweise erwartet, dass das Prüfsignal, welches in den Stromkreis 601 eingespeist wurde, im Wesentlichen an den Prüfsteckern 618, 619 des Prüfschalters 611 ausgegeben wird, beispielsweise mit veränderter Spannung im Falle einer Einspeisung an den Prüfsteckern 614, 615. Die Signalform wäre jedoch erwartungsgemäß im Wesentlichen unverändert. Ebenso wird bei richtig angeschlossenen elektrischen Komponenten beispielsweise erwartet, dass das in den Stromkreis 602 eingespeiste Signal im Wesentlichen an den Prüfsteckern 638, 639 des Prüfschalters 631 ausgegeben wird.

Bei einer fehlerhaften Verdrahtung, bei der beispielsweise Leitungen des ersten Stromkreises 601 und Leitungen des zweiten Stromkreises 602 vertauscht angeschlossen wurden, könnte hingegen das in den ersten Stromkreis 601 eingespeiste Signal in dem zweiten Stromkreis 602 vorhanden sein und/oder das in den zweiten Stromkreis 602 eingespeiste Signal in dem ersten Stromkreis 601 vorhanden sein.

Im Schritt 206 werden mehrere Messsignale erfasst, beispielsweise wie zuvor beschrieben an den Prüfschaltern 611 und 631. Die mehreren Messsignale können gleichzeitig oder nacheinander erfasst werden. In den Erfassungsvorrichtungen 651, 653 können die erfassten Messsignale optional vorbehandelt werden, beispielsweise durch Filterung.

Im Schritt 208 erfolgt eine Bestimmung einer Zuordnung zwischen Prüfsignalen und Messsignalen. Anders ausgedrückt erfolgt im Schritt 208 eine Identifikation der Prüfsignale in den Messsignalen. Die Identifikation der einzelnen Prüfsignale in den Messsignalen kann mittels Filter oder einer diskreten Fourier Transformation für die vierten Harmonischen erfolgen, wie zuvor in Verbindung mit dem Beispiel der Figur 1 beschrieben.

Anhand der im Schritt 208 bestimmten Zuordnung zwischen Prüfsignalen und Messsignalen kann auf einfache Art und Weise festgestellt werden, ob die erwarteten Prüfsignale an den entsprechenden Prüfsteckern 618, 619, 638 und 639 erfasst wurden. Bei nicht erwartungsgemäßen Zuordnungen kann eine fehlerhafte Verdrahtung festgestellt werden.

Im Schritt 210 werden Polaritäten der Messsignale, welche an den Prüfsteckern 618, 619, 638 und 639 erfasst wurden, bestimmt. Die Erkennung der Polarität basiert auf der im Zeitbereich asymmetrischen Signalform, wie es zuvor unter Bezugnahme auf die elektrische Anlage 150 der Figur 1 beschrieben wurde.

Im Schritt 212 können die so bestimmten Stromkreiszuordnungen und Polaritäten beispielsweise auf einer Anzeigevorrichtung für einen Benutzer ausgegeben werden.

Alternativ oder zusätzlich können im Schritt 214 die erkannten Stromkreiszuordnungen mit Soll-Zuordnungen und/oder die erkannten Polaritäten mit Soll-Polaritäten verglichen werden. Eine Warnung kann automatisch ausgegeben werden, wenn eine Abweichung zwischen dem erkannten Zustand und dem Soll-Zustand festgestellt wurde.

Zusammenfassend ermöglichen die oben beschriebenen unterschiedlichen Prüfsignale eine schnelle und zuverlässige Überprüfung der Verdrahtung der elektrischen Anlage. Die Prüfsignale haben eine im Zeitbereich asymmetrische Signalform und eine Kombination von vorgegebenen Harmonischen mit mindestens einer höheren Harmonischen aufweisen, wobei Amplitude und/oder Phase der mindestens einen höheren Harmonischen der mehreren Prüfsignale unterschiedlich sind. Durch die Gleichstromfreiheit der Prüfsignale treten keine Sättigungseffekte in beispielsweise Transformatoren oder Kondensatoren auf, sodass die Prüfsignale problemlos über Wandler übertragbar sind. Darüber hinaus erlauben die Prüfsignale eine Erkennung von Polaritätsfehlern und eine eindeutige Unterscheidung der einzelnen Phasen. Die Schwellenwerte, welche dabei zur Identifikation der höheren Harmonischen verwendet werden, können relativ in Bezug auf die Grundschwingung gewählt werden, sind also nicht von der absoluten Amplitude der Signale abhängig. Das Verfahren funktioniert daher auch bei Teilsignalen, welche beispielsweise durch Stromaufteilung oder bei unerwünschten Erdverbindungen auftreten können.

Die einzelnen unterschiedlichen Prüfsignale sowie auch Linearkombinationen daraus weisen gleiche im Zeitbereich asymmetrische Eigenschaften auf und können daher zuverlässig einer Polarität zugeordnet werden.

Durch die Verwendung zusätzlicher Harmonischer und/oder zusätzlich unterschiedlicher Amplituden können mehr als drei Phasen unterschieden werden. Dies ermöglicht zum Beispiel die gleichzeitige Unterscheidung weiterer Phasen, zum Beispiel in 2 x 3 Phasensystemen, oder die Verwendung einer Kodierung mit einer Hamming-Distanz größer eins, um eine Robustheit gegenüber Amplitudenfehlern zu verbessern.

## Patentansprüche

1. Verfahren zum Prüfen einer Verdrahtung einer elektrischen Anlage mit mehreren Stromkreisen, **gekennzeichnet durch**:

   - Erzeugen (202) mehreren Prüfsignale (160-162), wobei jedes der mehreren Prüfsignale (160-162) eine Kombination von vorgegebenen Harmonischen mit mindestens einer höheren Harmonischen aufweist, wobei

Amplitude und/oder Phase der mindestens einen höheren Harmonischen der mehreren Prüfsignale (160-162) unterschiedlich sind, und

- Einspeisen (204) der mehreren Prüfsignale (160-162) in mehrere erste Anschlüsse (142-144), die den mehreren Stromkreisen zugeordnet sind, an einer ersten Stelle (141) der elektrischen Anlage (100), wobei in jeden ersten Anschluss der mehreren ersten Anschlüsse (142-144) ein anderes Prüfsignal der mehreren Prüfsignale (160-162) eingespeist wird.

**2.** Verfahren Anspruch 1, wobei die mehreren Prüfsignale (160-162) gleichzeitig in die mehreren ersten Anschlüsse (142-144) eingespeist werden.

**3.** Verfahren nach Anspruch 1 oder Anspruch 2, wobei die mindestens eine höhere Harmonische vierte und/oder fünfte Harmonische umfasst.

**4.** Verfahren nach einem der vorhergehenden Ansprüche, wobei die Kombination von vorgegebenen Harmonischen zusätzlich zu einer Grundschwingung zumindest zweite und/oder dritte Harmonische umfasst.

**5.** Verfahren nach einem der vorhergehenden Ansprüche, wobei eine Grundschwingung der vorgegebenen Harmonischen eine Frequenz ungleich einer Netzfrequenz der elektrischen Anlage aufweist.

**6.** Verfahren nach einem der vorhergehenden Ansprüche, wobei eine Grundschwingung der vorgegebenen Harmonischen eine Frequenz im Bereich von 50 bis 60 **Hz** aufweist, optional eine Frequenz im Bereich von 51 bis 55 **Hz,** weiter optional eine Frequenz von 52,6 Hz.

**7.** Verfahren nach einem der vorhergehenden Ansprüche, wobei die mindestens eine höhere Harmonische vierte und fünfte Harmonische umfasst, wobei die vierte Harmonische einen Amplitudenfaktor von 1,35/16 oder 1/16 oder 0,65/16, und die fünfte Harmonische einen Amplitudenfaktor von 1,5/25 oder 1/25 oder 0,5/25 bezogen auf eine Amplitude einer Grundschwingung der vorgegebenen Harmonischen aufweist, wobei eine Amplitude einer der übrigen n-ten höheren Harmonischen der vorgegebenen Harmonischen einen Amplitudenfaktor von $1/n^2$ bezogen auf eine Amplitude der Grundschwingung der vorgegebenen Harmonischen aufweist.

**8.** Verfahren nach einem der vorhergehenden Ansprüche, wobei die mindestens eine höhere Harmonische vierte und fünfte Harmonische umfasst, wobei die vierte Harmonische einen Phasenversatz von +30° oder 0° oder -30°, und die fünfte Harmonische einen Phasenversatz von +30° oder 0° oder -30° bezogen auf eine Phase einer Grundschwingung der vorgegebenen Harmonischen aufweist.

**9.** Verfahren nach einem der vorhergehenden Ansprüche, ferner umfassend:

- Erfassen (206) von mehreren Messsignalen an mehreren zweiten Anschlüssen (146-148), die den mehreren Stromkreisen zugeordnet sind, an einer zweiten Stelle (145) der elektrischen Anlage (100).

**10.** Verfahren nach Anspruch 9, ferner umfassend:

- Bestimmen (208) von Zuordnungen zwischen jeweils einem ersten Anschluss der mehreren ersten Anschlüssen (142-144) und einem zweiten Anschluss der mehreren zweiten Anschlüssen (146-148) auf der Grundlage der eingespeisten Prüfsignale (160-162) und der erfassten Messsignale.

**11.** Verfahren nach Anspruch 10, wobei das Bestimmen (208) von Zuordnungen umfasst:

- Bestimmen von Amplituden und Phasen von Spektralkomponenten für Frequenzen der vorgegebenen Harmonischen in den Messsignalen, und
- Vergleichen der Amplituden und Phasen der Spektralkomponenten mit Amplitudenschwellenwerten bzw. Phasenschwellenwerten.

**12.** Verfahren nach Anspruch 11, wobei die Amplitudenschwellenwerte in Abhängigkeit von einer Amplitude einer Grundschwingung der vorgegebenen Harmonischen eingestellt werden.

**13.** Verfahren nach einem der Ansprüche 10-12, ferner umfassend:

- Ausgeben der Zuordnungen zwischen jeweils einem ersten Anschluss der mehreren ersten Anschlüssen und einem zweiten Anschluss der mehreren zweiten Anschlüssen an einen Benutzer, und/oder
- Vergleichen der Zuordnungen zwischen jeweils einem ersten Anschluss der mehreren ersten Anschlüsse und einem zweiten Anschluss der mehreren zweiten Anschlüsse mit vorgegebenen Zuordnungen zwischen jeweils einem ersten Anschluss der mehreren ersten Anschlüsse und einem zweiten Anschluss der mehreren zweiten Anschlüsse.

**14.** Verfahren nach einem der vorhergehenden Ansprüche, wobei jedes der mehreren Prüfsignale (160-162) eine im Zeitbereich asymmetrische Signalform aufweist.

**15.** Verfahren nach Anspruch 9 und Anspruch 14, ferner umfassend:

- Bestimmen (210) von Polaritäten der erfassten Messsignale, um abhängig von den bestimmten Polaritäten die Verdrahtung der elektrischen Anlage zu prüfen.

**16.** Verfahren nach Anspruch 15, wobei das Bestimmen (210) von Polaritäten der erfassten Messsignale für ein jeweiliges Messsignal der erfassten Messsignale umfasst:

- Bestimmen einer Ableitung eines jeweiligen Messsignals,
- Erzeugen eines Vergleichssignals durch Vergleichen der Ableitung mit einem Schwellenwert,
- Bestimmen eines Mittelwerts des Vergleichssignals, und
- Bestimmen der Polarität des jeweiligen Messsignals in Abhängigkeit von dem Mittelwert des Vergleichssignals.

**17.** Verfahren nach Anspruch 15, wobei das Bestimmen (210) von Polaritäten der erfassten Messsignale für ein jeweiliges Messsignal der erfassten Messsignale umfasst:

- Bestimmen eines Korrelationsfaktors in Abhängigkeit von einem jeweiligen Messsignal und der im Zeitbereich asymmetrische Signalform, und
- Bestimmen der Polarität des jeweiligen Messsignals in Abhängigkeit von dem Korrelationsfaktor.

**18.** Prüfvorrichtung zum Prüfen einer Verdrahtung einer elektrischen Anlage mit mehreren Stromkreisen, **gekennzeichnet durch**:

- eine Prüfsignalerzeugungsvorrichtung (152), die ausgestaltet ist, mehrere Prüfsignale (160-162) zu erzeugen, wobei jedes der mehreren Prüfsignale (160-162) eine Kombination von vorgegebenen Harmonischen mit mindestens einer höheren Harmonischen aufweist, wobei Amplitude und/oder Phase der mindestens einen höheren Harmonischen der mehreren Prüfsignale (160-162) unterschiedlich sind, und
- eine Einspeisevorrichtung (154), die ausgestaltet ist, an einer ersten Stelle (141) der elektrischen Anlage (100) die mehreren Prüfsignale (160-162) in mehrere erste Anschlüsse (142-144), die den mehreren Stromkreisen zugeordnet sind, einzuspeisen, wobei in jeden ersten Anschluss der mehreren ersten Anschlüsse (142-144) ein anderes Prüfsignal der mehreren Prüfsignale (160-162) eingespeist wird.

**19.** Prüfvorrichtung nach Anspruch 18, wobei die Prüfvorrichtung (150) zur Durchführung des Verfahrens nach einem der Ansprüche 1-8 ausgestaltet ist.

**20.** Prüfvorrichtung nach Anspruch 18 oder Anspruch 19, ferner umfassend:

- eine Erfassungsvorrichtung (156), die ausgestaltet ist, an einer zweiten Stelle (145) der elektrischen Anlage (100) mehrere Messsignale an mehreren zweiten Anschlüssen (146-148), die den mehreren Stromkreisen zugeordnet sind, zu erfassen.

**21.** Prüfvorrichtung nach Anspruch 20, ferner umfassend:

- eine Verarbeitungsvorrichtung (158), die ausgestaltet ist, Zuordnungen zwischen jeweils einem ersten Anschluss der mehreren ersten Anschlüsse (142-144) und einem zweiten Anschluss der mehreren zweiten Anschlüsse (146-148) auf der Grundlage der eingespeisten Prüfsignale (160-162) und der erfassten Messsignale zu bestimmen.

22. Prüfvorrichtung nach Anspruch 21, wobei die Prüfvorrichtung (150) zur Durchführung des Verfahrens nach einem der Ansprüche 9-17 ausgestaltet ist.

## Claims

1. A method for testing wiring of an electrical installation having multiple circuits, **characterized by**:

- generating (202) multiple test signals (160-162), wherein each of the multiple test signals (160-162) has a combination of predefined harmonics having at least one higher harmonic, wherein the amplitude and/or phase of the at least one higher harmonic of the multiple test signals (160-162) are different, and
- injecting (204) the multiple test signals (160-162) into multiple first connections (142-144), which are assigned to the multiple circuits, at a first point (141) of the electrical installation (100), wherein a different test signal of the multiple test signals (160-162) is injected into each first connection of the multiple first connections (142-144).

2. The method according to Claim 1, wherein the multiple test signals (160-162) are injected simultaneously into the multiple first connections (142-144).

3. The method according to Claim 1 or Claim 2, wherein the at least one higher harmonic comprises fourth and/or fifth harmonics.

4. The method according to one of the preceding claims, wherein the combination or predefined harmonics comprises, in addition to a fundamental, at least second and/or third harmonics.

5. The method according to one of the preceding claims, wherein a fundamental of the predefined harmonics has a frequency not equal to a mains frequency of the electrical installation.

6. The method according to one of the preceding claims, wherein a fundamental of the predefined harmonics has a frequency in the range of 50 to 60 Hz, optionally a frequency in the range of 51 to 55 Hz, again optionally a frequency of 52.6 Hz.

7. The method according to one of the preceding claims, wherein the at least one higher harmonic comprises fourth and fifth harmonics, wherein the fourth harmonic has an amplitude factor of 1.35/16 or 1/16 or 0.65/16, and the fifth harmonic has an amplitude factor of 1.5/25 or 1/25 or 0.5/25 relative to an amplitude of a fundamental of the predefined harmonics, wherein an amplitude of one of the other nth higher harmonics of the predefined harmonics has an amplitude factor of $1/n^2$ relative to an amplitude of the fundamental of the predefined harmonics.

8. The method according to one of the preceding claims, wherein the at least one higher harmonic comprises fourth and fifth harmonics, wherein the fourth harmonic has a phase offset of +30° or 0° or -30°, and the fifth harmonic has a phase offset of +30° or 0° or -30° relative to a phase of a fundamental of the predefined harmonics.

9. The method according to one of the preceding claims, furthermore comprising:

- acquiring (206) multiple measurement signals at multiple second connections (146-148), which are assigned to the multiple circuits, at a second point (145) of the electrical installation (100).

10. The method according to Claim 9, furthermore comprising:

- determining (208) assignments between in each case a first connection of the multiple first connections (142-144) and a second connection of the multiple second connections (146-148) on the basis of the injected test signals (160-162) and the acquired measurement signals.

11. The method according to Claim 10, wherein determining (208) assignments comprises:

- determining amplitudes and phases of spectral components for frequencies of the predefined harmonics in the measurement signals, and
- comparing the amplitudes and phases of the spectral components with amplitude threshold values or phase threshold values.

**12.** The method according to Claim 11, wherein the amplitude threshold values are set on the basis of an amplitude of a fundamental of the predefined harmonics.

**13.** The method according to one of Claims 10-12, furthermore comprising:

- outputting the assignments between in each case a first connection of the multiple first connections and a second connection of the multiple second connections to a user, and/or
- comparing the assignments between in each case a first connection of the multiple first connections and a second connection of the multiple second connections with predefined assignments between in each case a first connection of the multiple first connections and a second connection of the multiple second connections.

**14.** The method according to one of the preceding claims, wherein each of the multiple test signals (160-162) has a waveform that is asymmetric in the time domain.

**15.** The method according to Claim 9 and Claim 14, furthermore comprising:

- determining (210) polarities of the acquired measurement signals in order to test the wiring of the electrical installation depending on the determined polarities.

**16.** The method according to Claim 15, wherein determining (210) polarities of the acquired measurement signals for a respective measurement signal of the acquired measurement signals comprises:

- determining a derivative of a respective measurement signal,
- generating a comparison signal by comparing the derivative with a threshold value,
- determining an average of the comparison signal, and
- determining the polarity of the respective measurement signal on the basis of the average of the comparison signal.

**17.** The method according to Claim 15, wherein determining (210) polarities of the acquired measurement signals for a respective measurement signal of the acquired measurement signals comprises:

- determining a correlation factor on the basis of a respective measurement signal and the waveform that is asymmetric in the time domain, and
- determining the polarity of the respective measurement signal on the basis of the correlation factor.

**18.** A test device for testing wiring of an electrical installation having multiple circuits, **characterized by**:

- a test signal generation device (152) that is configured to generate multiple test signals (160-162), wherein each of the multiple test signals (160-162) has a combination of predefined harmonics having at least one higher harmonic, wherein the amplitude and/or phase of the at least one higher harmonic of the multiple test signals (160-162) are different, and
- an injection device (154) that is configured to inject the multiple test signals (160-162) into multiple first connections (142-144), which are assigned to the multiple circuits, at a first point (141) of the electrical installation (100), wherein a different test signal of the multiple test signals (160-162) is injected into each first connection of the multiple first connections (142-144).

**19.** The test device according to Claim 18, wherein the test device (150) is configured to perform the method according to one of Claims 1-8.

**20.** The test device according to Claim 18 or Claim 19, furthermore comprising:

- an acquisition device (156) that is configured to acquire multiple measurement signals at multiple second connections (146-148), which are assigned to the multiple circuits, at a second point (145) of the electrical installation (100).

**21.** The test device according to Claim 20, furthermore comprising:

- a processing device (158) that is configured to determine assignments between in each case a first connection of

the multiple first connections (142-144) and a second connection of the multiple second connections (146-148) on the basis of the injected test signals (160-162) and the acquired measurement signals.

**22.** The test device according to Claim 21, wherein the test device (150) is configured to perform the method according to one of Claims 9-17.

**Revendications**

**1.** Procédé de contrôle du câblage d'une installation électrique comportant une pluralité de circuits, **caractérisé par** :

- générer (202) une pluralité de signaux de contrôle (160-162), chacun de la pluralité de signaux de contrôle (160-162) présentant une combinaison d'harmoniques prédéterminées avec au moins une harmonique supérieure, l'amplitude et/ou la phase d'au moins une harmonique supérieure de la pluralité de signaux de contrôle (160-162) étant différentes, et
- alimenter (204) la pluralité de signaux de contrôle (160-162) dans une pluralité de premières bornes (142-144) associées à la pluralité de circuits, en un premier emplacement (141) de l'installation électrique (100), un signal de contrôle différent de la pluralité de signaux de contrôle (160-162) étant alimenté dans chaque première borne de la pluralité de premières bornes (142-144).

**2.** Procédé selon la revendication 1, dans lequel la pluralité de signaux de contrôle (160-162) sont alimentés simultanément dans la pluralité de premières bornes (142-144).

**3.** Procédé selon la revendication 1 ou la revendication 2, dans lequel la au moins une harmonique supérieure comprend la quatrième et/ou la cinquième harmonique.

**4.** Procédé selon l'une quelconque des revendications précédentes, dans lequel la combinaison d'harmoniques prédéterminées comprend au moins une deuxième et/ou troisième harmonique en plus d'une oscillation fondamentale.

**5.** Procédé selon l'une quelconque des revendications précédentes, dans lequel une oscillation fondamentale des harmoniques prédéterminées a une fréquence non égale à une fréquence de réseau de l'installation électrique.

**6.** Procédé selon l'une des revendications précédentes, dans lequel une oscillation fondamentale des harmoniques prédéterminées présente une fréquence comprise entre 50 et 60 Hz, éventuellement une fréquence comprise entre 51 et 55 Hz, ou encore, éventuellement, une fréquence de 52,6 Hz.

**7.** Procédé selon l'une quelconque des revendications précédentes, dans lequel la au moins une harmonique supérieure comprend une quatrième et cinquième harmonique, la quatrième harmonique ayant un facteur d'amplitude de 1,35/16 ou 1/16 ou 0,65/16, et la cinquième harmonique ayant un facteur d'amplitude de 1,5/25 ou 1/25 ou 0,5/25 par rapport à une amplitude d'une oscillation fondamentale des harmoniques prédéterminées, une amplitude de l'une des nièmes harmoniques supérieures restantes des harmoniques prédéterminées ayant un facteur d'amplitude de $1/n^2$ par rapport à une amplitude de l'oscillation fondamentale des harmoniques prédéterminées.

**8.** Procédé selon l'une des revendications précédentes, dans lequel la au moins une harmonique supérieure comprend une quatrième et une cinquième harmonique, la quatrième harmonique présentant un déphasage de +30°, 0° ou -30°, et la cinquième harmonique présentant un déphasage de +30°, 0° ou -30° par rapport à une phase d'une oscillation fondamentale de l'harmonique prédéterminée.

**9.** Procédé selon l'une quelconque des revendications précédentes, comprenant en outre :

- détecter (206) une pluralité de signaux de mesure sur une pluralité de deuxièmes bornes (146-148) associées à la pluralité de circuits, en un second emplacement (145) de l'installation électrique (100).

**10.** Procédé selon la revendication 9, comprenant en outre :

- déterminer (208) des correspondances entre respectivement une première borne de la pluralité de premières bornes (142-144) et une seconde borne de la pluralité de secondes bornes (146-148) sur la base des signaux de

contrôle alimentés (160-162) et des signaux de mesure détectés.

**11.** Procédé selon la revendication 10, dans lequel la détermination (208) des correspondances comprend :

- déterminer des amplitudes et des phases des composantes spectrales pour les fréquences des harmoniques prédéterminées dans les signaux de mesure, et
- comparer des amplitudes et des phases des composantes spectrales avec des seuils d'amplitude et des seuils de phase respectivement.

**12.** Procédé selon la revendication 11, dans lequel les seuils d'amplitude sont réglés en fonction d'une amplitude d'une oscillation fondamentale de l'harmonique prédéterminée.

**13.** Procédé selon l'une quelconque des revendications 10-12, comprenant en outre :

- délivrer à un utilisateur les correspondances entre respectivement une première borne de la pluralité de premières bornes et une deuxième borne de la pluralité de deuxièmes bornes et/ou
- comparer les correspondances entre respectivement une première borne de la pluralité de premières bornes et une deuxième borne de la pluralité de deuxièmes bornes avec des correspondances prédéterminées entre respectivement une première borne de la pluralité de premières bornes et une deuxième borne de la pluralité de deuxièmes bornes.

**14.** Procédé selon l'une quelconque des revendications précédentes, dans lequel chacun de la pluralité de signaux de contrôle (160-162) a une forme d'onde asymétrique dans le domaine temporel.

**15.** Procédé selon la revendication 9 et la revendication 14, comprenant en outre :

- déterminer (210) des polarités des signaux de mesure détectés afin de vérifier, en fonction des polarités déterminées, le câblage de l'installation électrique.

**16.** Procédé selon la revendication 15, dans lequel la détermination (210) des polarités des signaux de mesure détectés pour un signal de mesure respectif des signaux de mesure détectés comprend :

- déterminer une dérivée d'un signal de mesure respectif,
- générer un signal de comparaison en comparant la dérivée à une valeur seuil,
- déterminer une valeur moyenne du signal de comparaison, et
- déterminer la polarité du signal de mesure respectif en fonction de la valeur moyenne du signal de comparaison.

**17.** Procédé selon la revendication 15, dans lequel la détermination (210) des polarités des signaux de mesure détectés pour un signal de mesure respectif des signaux de mesure détectés comprend :

- déterminer un facteur de corrélation en fonction d'un signal de mesure respectif et de la forme d'onde asymétrique dans le domaine temporel, et
- déterminer la polarité du signal de mesure respectif en fonction du facteur de corrélation.

**18.** Dispositif de contrôle du câblage d'une installation électrique comportant une pluralité de circuits, **caractérisé par** :

- un dispositif de génération de signaux de contrôle (152), conçu pour générer une pluralité de signaux de contrôle (160-162), chacun de la pluralité de signaux de contrôle (160-162) présentant une combinaison d'harmoniques prédéterminées avec au moins une harmonique supérieure, l'amplitude et/ou la phase d'au moins une harmonique supérieure de la pluralité de signaux de contrôle (160-162) étant différentes, et
- un dispositif d'alimentation (154) qui est configuré pour alimenter, en un premier emplacement (141) de l'installation électrique (100), la pluralité de signaux de contrôle (160-162) dans une pluralité de premières bornes (142-144) associées à la pluralité de circuits électriques, un signal de contrôle différent de la pluralité de signaux de contrôle (160-162) étant alimenté dans chaque première borne de la pluralité de premières bornes (142-144).

**19.** Dispositif de contrôle selon la revendication 18, dans lequel le dispositif de contrôle (150) est configuré pour mettre en œuvre le procédé selon l'une quelconque des revendications 1-8.

**20.** Dispositif de contrôle selon la revendication 18 ou la revendication 19, comprenant en outre :

- un dispositif de détection (156) configuré pour détecter, en un deuxième emplacement (145) de l'installation électrique (100), une pluralité de signaux de mesure sur une pluralité de deuxièmes bornes (146-148) associées à la pluralité de circuits électriques.

**21.** Dispositif de contrôle selon la revendication 20, comprenant en outre :

- un dispositif de traitement (158) configuré pour déterminer des correspondances entre une première borne respective de la pluralité de premières bornes (142-144) et une deuxième borne respective de la pluralité de deuxièmes bornes (146-148) sur la base des signaux de contrôle alimentés (160-162) et des signaux de mesure détectés.

**22.** Dispositif de contrôle selon la revendication 21, dans lequel le dispositif de contrôle (150) est configuré pour mettre en œuvre le procédé selon l'une quelconque des revendications 9-17.

100
125
141
112
114
145
135
110
120
142
146
130
121
143
147
131
122
144
148
132
172
171
170
180
181
182
150
156
154
162
161
152
160
158

**FIG. 1**

200
Erzeugen mehrerer Prüfsignale
202
Einspeisen der Prüfsignale an einer ersten Stelle
204
Erfassen mehrerer Messsignale an einer zweiten Stelle
206
Bestimmen einer Zuordnung zwischen Prüfsignalen und Messsignalen
208
Bestimmen von Polaritäten der Messsignale
210
Ausgeben der Zuordnungen und/oder Polaritäten
212
Vergleichen der Zuordnungen mit Soll-Zuordnungen und/oder Polaritäten mit Soll-Polaritäten
214

**FIG. 2**

1,5
1
0,5
0
-0,5
-1
-1,5
0
5
10
15
20
25
30
35
40
Phase 1
Phase 2
Phase 3
unverändert


FIG. 3

800
600
400
200
0
-200
-400
0
5
10
15
20
25
30
35
40
Phase 1
Phase 2
Phase 3

FIG. 4

Q1(t)
T
t

FIG. 5

600
601
602
613
633
650
651
652
653
654
655
610
611
612
614
615
616
617
618
619
620
630
631
632
634
635
636
637
638
639
640

FIG. 6

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

• JP 2023096699 A